# EUROPEAN PATENT APPLICATION

(11) **EP 4 671 220 A1**
(43) Date of publication of application: **31.12.2025**
(21) Application number: 25173447.1
(22) Date of filing: 30.04.2025
(51) Int. Cl.: C03C 17/36, H01L 23/15

(54) **HYBRID PANEL WITH A GLASS SUBSTRATE AND PLATED FRAME**

(30) Priority: 26.06.2024 US 202418755176
(71) Applicant: INTEL Corporation, Santa Clara, CA 95054 (US)
(72) Inventor: BRYKS, Whitney, Chandler, 85284 (US); CHEN, Haobo, Chandler, AZ, 85249 (US); DUAN, Gang, Chandler AZ, 85248 (US); DUONG, Benjamin, Phoenix, AZ, 85044 (US); JONES, Jesse, Chandler, AZ, 85248 (US); MARIN, Brandon C., Gilbert, 85234 (US); MAY, Robert, Chandler AZ, 85249 (US); NIE, Bai, Chandler, AZ, 85249 (US); RAMANUJA PIETAMBARAM, Srinivas Venkata, Chandler, 85249 (US); SHAN, Bohan, Chandler, AZ, 85226 (US); TANAKA, Hiroki, GILBERT, Arizona, 85295 (US)
(74) Representative: HGF

(57) **Abstract**

Embodiments disclosed herein include an apparatus that comprises a substrate. In an embodiment, the substrate comprises a glass layer. In an embodiment, a frame is provided around a perimeter of the substrate. In an embodiment, the frame is over a top surface, a bottom surface, and a sidewall surface of the substrate. In an embodiment, the frame comprises a conductive material.

## Description

### BACKGROUND

Electronics packaging substrates often include a core. Existing core materials include organic dielectrics that may include fiber reinforcement materials. As devices continue to become more complex, better performing core materials are desired. A package core that includes a solid glass layer is one potential option. Glass cores enable stiffer substrates, flatter surfaces, and can improve electrical performance.

However, the fragile nature of glass makes full-size glass panel edges extremely vulnerable to damage due to frequent contact of the edges during handling and processing. Designated toolsets that can handle and process glass panels need to be specially designed, and they are not widely available in the industry. This leads to a high technology improvement cost in order to enable a switch from organic core processing to glass core processing in a high volume manufacturing (HVM) environment.

### BRIEF DESCRIPTION OF THE DRAWINGS

Figures 1A- 1F are cross-sectional illustrations depicting a process for forming a hybrid panel with a plated frame, in accordance with an embodiment.
Figures 2A - 2F are cross-sectional illustrations depicting a process for forming a hybrid panel with an adhesion layer and a buildup layer between the frame and the glass substrate, in accordance with an embodiment.
Figures 3A - 3E are cross-sectional illustrations depicting a process for forming a hybrid panel with a buildup layer between the frame and the glass substrate, in accordance with an embodiment.
Figures 4A- 4H are cross-sectional illustrations and a plan view illustration depicting a process for forming a hybrid panel with a frame around a glass substrate and a buffer layer over the glass substrate and the frame, in accordance with an embodiment.
Figure 5 is a flow diagram depicting a process for forming a hybrid panel with a metal frame plated onto a glass substrate, in accordance with an embodiment.
Figures 6A- 6H are cross-sectional illustrations and a plan view illustration of a process for forming a hybrid panel with a frame that includes a cross across the glass substrate, in accordance with an embodiment.
Figures 7A- 7H are cross-sectional illustrations and a plan view illustration of a process for forming a hybrid panel with a frame that includes a cross across the glass substrate with a via first process, in accordance with an embodiment.
Figures 8A- 8I are cross-sectional illustrations and a plan view illustration of a process for forming a hybrid panel with a frame that is separated from the glass substrate by a buildup layer, in accordance with an embodiment.
Figure 9 is a flow diagram of a process for forming a hybrid panel with a plated frame that includes a cross across the glass substrate, in accordance with an embodiment.
Figures 10A - 10C are plan view and corresponding cross-sectional illustrations of hybrid panels that have plated frames with dummy vias, in accordance with an embodiment.
Figures 11A and 11B are plan view and corresponding cross-sectional illustrations of a hybrid panel that has a frame with dummy vias at the edge and through a center of the glass substrate, in accordance with an embodiment.
Figures 12A- 12G are plan view and corresponding cross-sectional illustrations of process for forming a hybrid panel with a plated frame that comprises dummy vias, in accordance with an embodiment.
Figures 13A - 13D are plan view and corresponding cross-sectional illustrations of a process for forming a hybrid panel with a plated frame that comprises dummy vias, in accordance with an embodiment.
Figure 14 is a flow diagram of a process for forming a hybrid panel with a plated frame that comprises dummy vias, in accordance with an embodiment.
Figures 15A 15I are cross-sectional illustrations depicting a process for forming hybrid panels with plated frames with the use of carrier substrates, in accordance with an embodiment.
Figures 16A - 16I are cross-sectional illustrations depicting a process for forming hybrid panels with a plated frames with the use of carrier substrates and a buildup layer around the glass substrate, in accordance with an embodiment.
Figure 17 is a flow diagram of a process for forming a hybrid panel with a plated frame with the use of carrier substrates, in accordance with an embodiment.

### EMBODIMENTS OF THE PRESENT DISCLOSURE

Described herein are hybrid panels with a glass substrate and a plated frame around the glass substrate, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, package substrates that include glass cores have the potential to improve some manufacturing processes and enable higher performing devices compared to existing organic core solutions. However, glass substrates are fragile. For example, contact to the edge of the glass substrate can lead to chipping, cracking, and/or the like. The development of new processing tools is one option for handling glass core substrates, but such an approach would be expensive.

Frames have been used in order to protect the glass substrates. Typically, the frames include a copper clad laminate (CCL) that is provided around the glass substrate. However, manufacture of the frame increases overall assembly cost. The glass substrate is manually placed within the frame, which increases the difficulty of achieving good placement accuracy. Encapsulation of the frame and glass substrate to secure the two components together can also lead to difficult material selection choices and thickness uniformity problems.

Accordingly, embodiments disclosed herein may include an in-situ frame assembly process that directly applies the frame to the glass substrate. Particularly, embodiments disclosed herein directly plate a metallic frame onto the glass substrate. The plated metallic frame results in there being no misalignment between the glass substrate and the frame. Further, there is no need for an overmolding material that mechanically couples the glass substrate to the frame. As such, thickness uniformity of the hybrid panel remains excellent. Since the frame is plated with the in-situ process, there is also no need for the separate manufacture of frame components.

In an embodiment, the hybrid frame comprises a glass substrate with a frame that wraps around a perimeter of the glass substrate. The frame may comprise a metallic material, such as copper. In an embodiment, the frame may cover a sidewall of the glass substrate in addition to edge portions of the top surface and the bottom surface of the glass substrate. Such an embodiment may be formed with a process that comprises applying a resist layer, such as a polymer, over a central portion of the glass substrate after a seed layer is applied over all surface of the glass substrate. The frame can then be plated with an electroplating process. The resist and the portions of the seed layer underlying the resist can be removed to expose the glass substrate. In some embodiments, a dielectric layer (with or without an adhesion promoting layer) can also be provided around the glass substrate before the seed layer is applied.

In yet another embodiment, the resist layer may be a photoimageable resist material. In such an embodiment, the resist may be patterned to form a frame that includes a cross over the glass substrate. The cross may be used in order to segregate quarter panel regions or unit regions of the glass substrate for further processing.

Embodiments disclosed herein may also comprise hybrid panels that include frames with dummy vias that pass through the glass substrate. The dummy vias may provide improved mechanical anchoring of the frame to the glass substrate, in order. The dummy vias may be provided around a perimeter of the glass substrate and/or through a middle of the glass substrate below a cross of the frame.

Embodiments disclosed herein may also comprise a hybrid panel that is formed with a process that comprises the use of carrier substrates. In such an embodiment, the carrier substrates block the top and bottom surfaces of the glass substrate from plating, and the frame is provided only along the sidewall surfaces of the glass substrate. Depending on the particular embodiment, the frame may be a linear frame, or the frame may have protrusions at the top and bottom that extend away from the glass substrate.

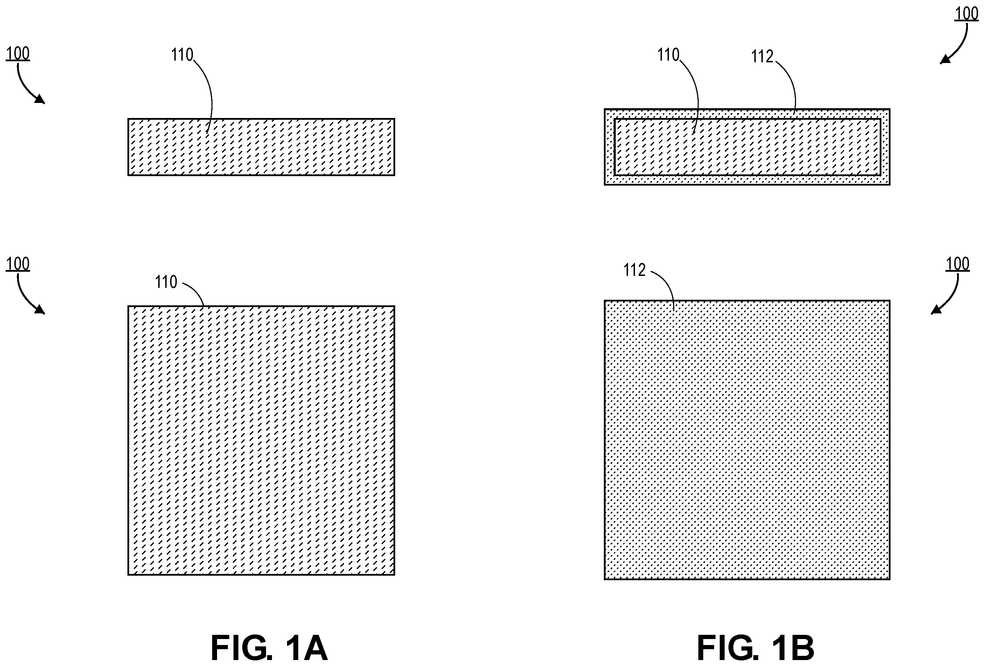

Referring now to Figures 1A- 1F, a series of plan view illustrations and corresponding cross-sectional illustrations depicting a process for forming a hybrid panel 100 is shown, in accordance with an embodiment. In Figures 1A - 1F, the bottom drawing is the plan view, and the upper drawing is the corresponding cross-sectional view.

Referring now to Figure 1A, illustrations of a hybrid panel 100 at a stage of manufacture are shown, in accordance with an embodiment. At this stage, the hybrid panel comprises a glass substrate 110. The glass substrate 110 may have any suitable form factor. In a particular embodiment, the glass substrate 110 comprises a panel form factor or a quarter panel form factor. In an embodiment, the glass substrate 110 comprises a glass material that is suitable for forming the core of a package substrate.

In an embodiment, the glass substrate 110 may be substantially all glass. The glass substrate 110 may be a solid mass comprising a glass material with an amorphous crystal structure where the solid glass core may also include various structures - such as vias, cavities, channels, or other features - that are filled with one or more other materials (e.g., metals, metal alloys, dielectric materials, etc.). As such, glass substrate 110 may be distinguished from, for example, the "prepreg" or "FR4" core of a Printed Circuit Board (PCB) substrate which typically comprises glass fibers embedded in a resinous organic material, such as an epoxy.

The glass substrate 110 may have any suitable dimensions. In a particular embodiment, the glass substrate 110 may have a thickness that is approximately 50µm or greater. For example, the thickness of the glass substrate 110 may be between approximately 50µm and approximately 1.4mm. Though, smaller or larger thicknesses may also be used. Individual units (after singulation) from the glass substrate 110 may have edge dimensions (e.g., length, width, etc.) that are approximately 10mm or greater. For example, edge dimensions may be between approximately 10mm to approximately 250mm. Though, larger or smaller edge dimensions may also be used. More generally, the area dimensions of the individual units in the glass substrate 110 (from an overhead plan view) may be between approximately 10mm x 10mm and approximately 250mm x 250mm. In an embodiment, the glass substrate 110 may have a first side that is perpendicular or orthogonal to a second side. In a more general embodiment, the glass substrate 110 may comprise a rectangular prism volume with sections (e.g., vias) removed and filled with other materials (e.g., metal, etc.).

The glass substrate 110 may comprise a single monolithic layer of glass. In other embodiments, the glass substrate 110 may comprise two or more discrete layers of glass that are stacked over each other. The discrete layers of glass may be provided in direct contact with each other, or the discrete layers of glass may be mechanically coupled to each other by an adhesive or the like. The discrete layers of glass in the glass substrate 110 may each have a thickness less than approximately 50µm. For example, discrete layers of glass in the glass substrate 110 may have thicknesses between approximately 25µm and approximately 50µm. Though, discrete layers of glass may have larger or smaller thicknesses in some embodiments. As used herein, "approximately" may refer to a range of values within ten percent of the stated value. For example approximately 50µm may refer to a range between 45µm and 55µm.

The glass substrate 110 may be any suitable glass formulation that has the necessary mechanical robustness and compatibility with semiconductor packaging manufacturing and assembly processes. For example, the glass substrate 110 may comprise aluminosilicate glass, borosilicate glass, alumino-borosilicate glass, silica, fused silica, or the like. In some embodiments, the glass substrate 110 may include one or more additives, such as, but not limited to, Al₂O₃, B₂O₃, MgO, CaO, SrO, BaO, SnO₂, Na₂O, K₂O, SrO, P₂O₃, ZrO₂, Li₂O, Ti, or Zn. More generally, the glass substrate 110 may comprise silicon and oxygen, as well as any one or more of aluminum, boron, magnesium, calcium, barium, tin, sodium, potassium, strontium, phosphorus, zirconium, lithium, titanium, or zinc. In an embodiment, the glass substrate 110 may comprise at least 23 percent silicon (by weight) and at least 26 percent oxygen (by weight). In some embodiments, the glass substrate 110 may further comprise at least 5 percent aluminum (by weight).

Referring now to Figure 1B, illustrations of the hybrid panel 100 after a seed layer 112 is deposited are shown, in accordance with an embodiment. In an embodiment, the seed layer 112 may be deposited with any suitable deposition process. For example, an electroless plating process, a sputtering process, an atomic layer deposition (ALD) process, a chemical vapor deposition (CVD) process, or the like may be used in order to deposit the seed layer 112. The seed layer 112 may be deposited over all surfaces of the glass substrate 110. That is, the seed layer 112 may be provided on a top surface, a bottom surface, and sidewall surfaces of the glass substrate 110. In an embodiment, the seed layer 112 may comprise any suitable electrically conductive material. For example, the seed layer 112 may comprise one or more of copper, titanium, platinum, or the like.

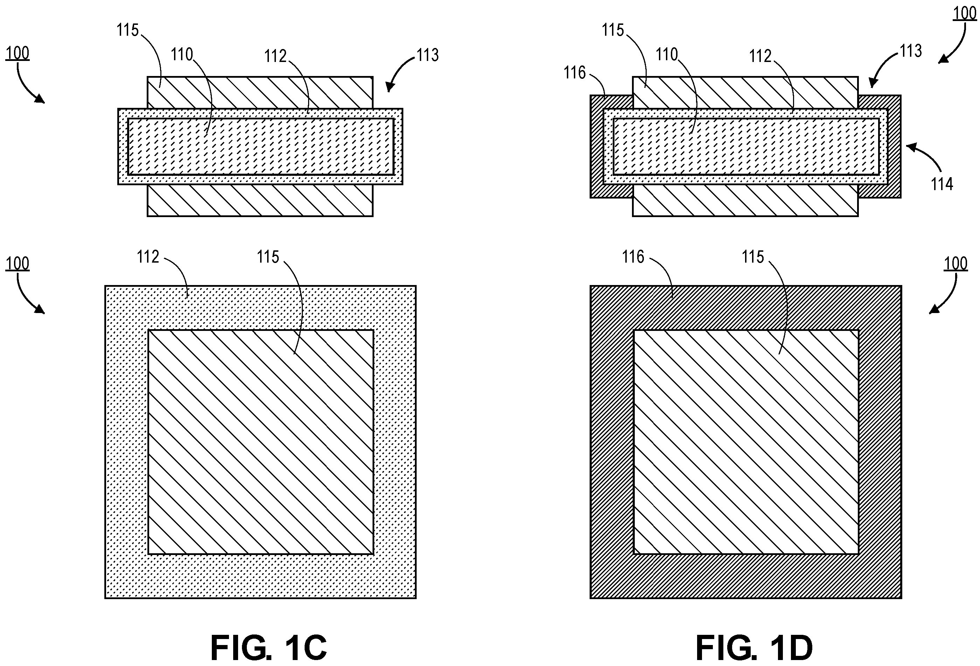

Referring now to Figure 1C, illustrations of the hybrid panel 100 after a resist layer 115 is applied over and under the glass substrate 110 are shown, in accordance with an embodiment. The resist layer 115 may be applied with any suitable process, such as a lamination process. The resist layer 115 may be provided as a sheet with a footprint that is smaller than a footprint of the glass substrate 110. As shown, an outer edge region 113 of the seed layer 112 remains exposed around a perimeter of the resist layer 115. In an embodiment, the resist layer 115 may comprise a polymer material, such as a polyester material.

Referring now to Figure 1D, illustrations of the hybrid panel 100 after a frame 116 is formed on the glass substrate 110 are shown, in accordance with an embodiment. In an embodiment, the frame 116 may be an electrically conductive material, such as a material comprising copper. The frame 116 may be plated from the seed layer 112 with an electroplating process. Since the resist layer 115 blocks portions of the seed layer 112, the frame 116 is selectively formed along the outer edge region 113 of the hybrid panel 100. Further, since the sidewall portions 114 of the seed layer 112 are also exposed, the frame 116 plates up along the sidewall portions 114. Accordingly, the frame 116 comprises a first portion over a top surface of the glass substrate 110, a second portion under a bottom surface of the glass substrate 110, and a third portion along the sidewall surface of the glass substrate 110. In a cross-sectional view (i.e., the top drawing in Figure 1D), the frame 116 may comprise a C-shaped cross section on one edge of the glass substrate 110 and a backwards C-shaped cross-section on the second edge of the glass substrate 110.

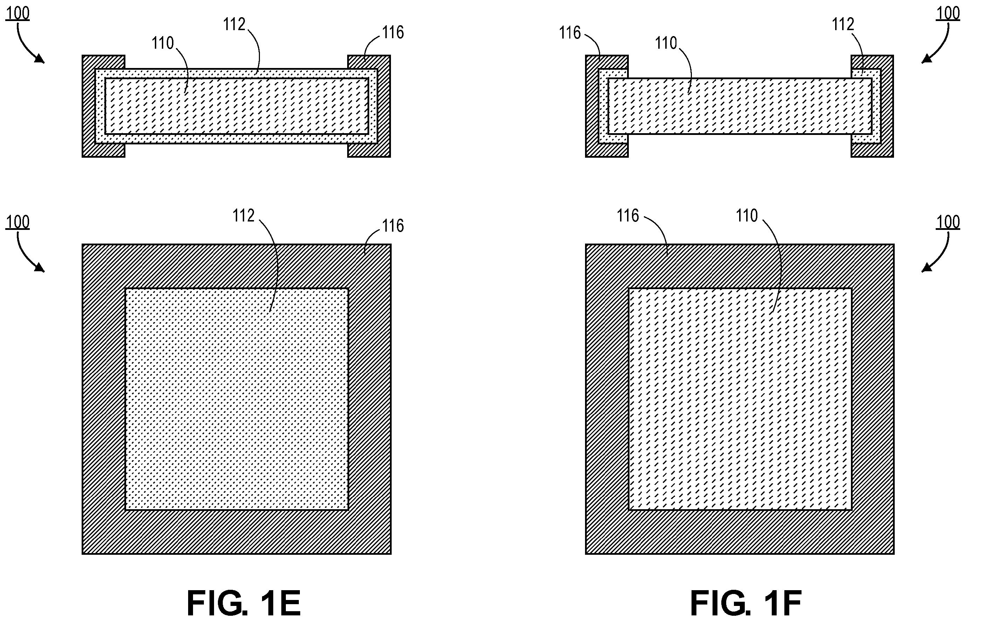

Referring now to Figure 1E, illustrations of the hybrid panel 100 after the resist layer 115 is removed are shown, in accordance with an embodiment. In an embodiment, the resist layer 115 may be removed with any suitable resist stripping process, etching process, or the like. The removal of the resist layer 115 exposes portions of the seed layer 112 between the edges of the frame 116.

Referring now to Figure 1F, illustrations of the hybrid panel 100 after the exposed portions of the seed layer 112 are removed are shown, in accordance with an embodiment. The seed layer 112 may be removed with an etching process. The removal of the seed layer 112 exposes the glass substrate 110 again. After the glass substrate 110 is exposed, the processing may continue with any typical panel level processing (e.g., via formation through the glass substrate 110, buildup layer and routing formation above and/or below the glass substrate 110, etc.).

As can be appreciated, the depicted in-situ frame 116 formation process allows for perfect alignment between the frame 116 and the glass substrate 110. Additionally, since the frame 116 wraps around the sidewall of the glass substrate 110 (to cover a top surface, a sidewall surface, and a bottom surface), the adhesion between the frame 116 and the glass substrate 110 is improved compared to providing a frame 116 only on the sidewall surface of the glass substrate 110.

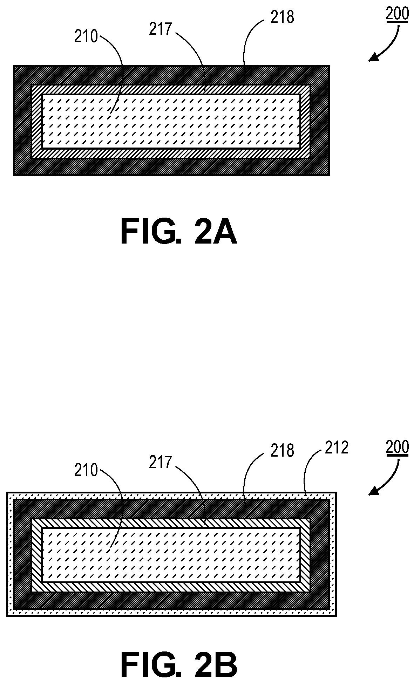

Referring now to Figures 2A - 2F, a series of cross-sectional illustrations depicting a process for forming a hybrid panel 200 is shown, in accordance with an additional embodiment. In an embodiment, the hybrid panel 200 may be similar to the hybrid panel 100 described above, with the exception of the addition of a buildup layer 218 and an adhesion layer 217 over the glass substrate 210. The buildup layer 218 may further protect the glass substrate 210 and/or provide improved adhesion between the frame 216 and the glass substrate 210. Improved adhesion strength may be particularly beneficial when the coefficient of thermal expansion (CTE) mismatch between the glass substrate 210 and the frame 216 is high.

Referring now to Figure 2A, a cross-sectional illustration of the hybrid panel 200 at a stage of manufacture is shown, in accordance with an embodiment. The hybrid panel 200 may comprise a glass substrate 210. The glass substrate 210 may be similar to any of the glass substrates described in greater detail herein. In an embodiment, a buildup layer 218 is applied over the surfaces of the glass substrate 210. The buildup layer 218 may be on the top surface, the bottom surface, and sidewall surfaces of the glass substrate 210. The buildup layer 218 may comprise an organic dielectric material, such as a traditional buildup film material used in electronics packaging applications. In an embodiment, the buildup layer 218 may be separated from the glass substrate 210 by an adhesion layer 217. The adhesion layer 217 may be a material that is tuned to improve adhesion strength between the buildup layer 218 and the glass substrate 210. In some instances, the adhesion layer 217 is an inorganic material, such as silicon nitride or the like.

Referring now to Figure 2B, a cross-sectional illustration of the hybrid panel 200 after a seed layer 212 is applied over the buildup layer 218 is shown, in accordance with an embodiment. In an embodiment, the seed layer 212 may be similar to any of the seed layers described in greater detail herein. The seed layer 212 may be applied over all exposed surfaces of the buildup layer 218 with any suitable process, such as those described in greater detail herein.

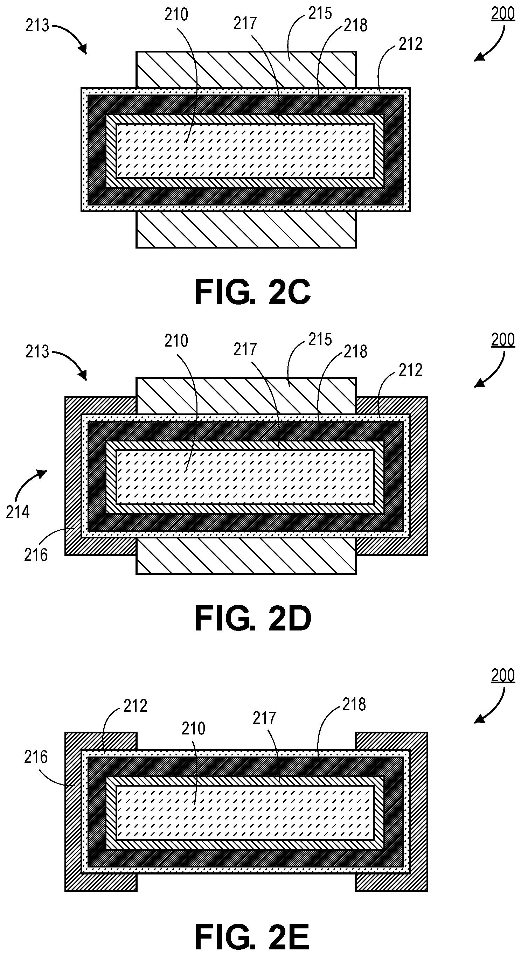

Referring now to Figure 2C, a cross-sectional illustration of the hybrid panel 200 after a resist layer 215 is applied over the seed layer 212 is shown, in accordance with an embodiment. The resist layer 215 may be applied over a top surface and a bottom surface of the glass substrate 210. The resist layer 215 may have a footprint that is smaller than a footprint of the glass substrate 210. As such, outer edge regions 213 of the seed layer 212 remains exposed. In an embodiment, the resist layer 215 may comprise a polymer material, such as polyester or the like. The resist layer 215 may be similar to any of the resist layers described in greater detail herein, and the resist layer 215 may be applied with any suitable process, such as a lamination process or the like.

Referring now to Figure 2D, a cross-sectional illustration of the hybrid panel 200 after a frame 216 is formed on the glass substrate 210 is shown, in accordance with an embodiment. In an embodiment, the frame 216 may be an electrically conductive material, such as a material comprising copper. The frame 216 may be plated from the seed layer 212 with an electroplating process. Since the resist layer 215 blocks portions of the seed layer 212, the frame 216 is selectively formed along the outer edge region 213 of the hybrid panel 200. Further, since the sidewall portions 214 of the seed layer 212 are also exposed, the frame 216 plates up along the sidewall portions 214. Accordingly, the frame 216 comprises a first portion over a top surface of the glass substrate 210, a second portion under a bottom surface of the glass substrate 210, and a third portion along the sidewall surface of the glass substrate 210. In an embodiment, the frame 216 may comprise a C-shaped cross section on one edge of the glass substrate 210 and a backwards C-shaped cross-section on the second edge of the glass substrate 210.

Referring now to Figure 2E, a cross-sectional illustration of the hybrid panel 200 after the resist layer 215 is removed is shown, in accordance with an embodiment. In an embodiment, the resist layer 215 may be removed with any suitable resist stripping process, etching process, or the like. The removal of the resist layer 215 exposes portions of the seed layer 212 between the edges of the frame 216.

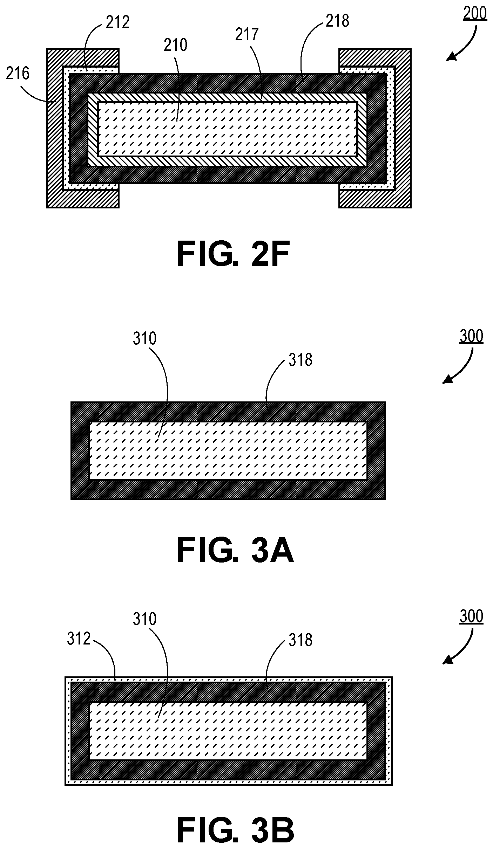

Referring now to Figure 2F, illustrations of the hybrid panel 200 after the exposed portions of the seed layer 212 are removed are shown, in accordance with an embodiment. The seed layer 212 may be removed with an etching process. The removal of the seed layer 212 exposes the buildup layer 218 again. After the buildup layer 218 is exposed, the processing may continue with any typical panel level processing (e.g., via formation through the glass substrate 210, additional buildup layer formation, the formation of electrical routing in the buildup layers, etc.).

As can be appreciated, the depicted in-situ frame 216 formation process allows for perfect alignment between the frame 216 and the glass substrate 210. Additionally, since the frame 216 wraps around the sidewall of the glass substrate 210 (to cover a top surface, a sidewall surface, and a bottom surface), the adhesion between the frame 216 and the glass substrate 210 is improved compared to providing a frame 216 only on the sidewall surface of the glass substrate 210.

Referring now to Figure 3A, a cross-sectional illustration of the hybrid panel 300 at a stage of manufacture is shown, in accordance with an embodiment. The hybrid panel 300 may comprise a glass substrate 310. The glass substrate 310 may be similar to any of the glass substrates described in greater detail herein. In an embodiment, a buildup layer 318 is applied over the surfaces of the glass substrate 310. The buildup layer 318 may be on the top surface, the bottom surface, and sidewall surfaces of the glass substrate 310. The buildup layer 318 may comprise an organic dielectric material, such as a traditional buildup film material used in electronics packaging applications. In an embodiment, the buildup layer 318 may be provided in direct contact with the glass substrate 310. In such an embodiment, the adhesion strength between the buildup layer 318 and the glass substrate 310 may be sufficient so that an additional adhesion layer is not necessary.

Referring now to Figure 3B, a cross-sectional illustration of the hybrid panel 300 after a seed layer 312 is applied over the buildup layer 318 is shown, in accordance with an embodiment. In an embodiment, the seed layer 312 may be similar to any of the seed layers described in greater detail herein. The seed layer 312 may be applied over all exposed surfaces of the buildup layer 318 with any suitable process, such as those described in greater detail herein.

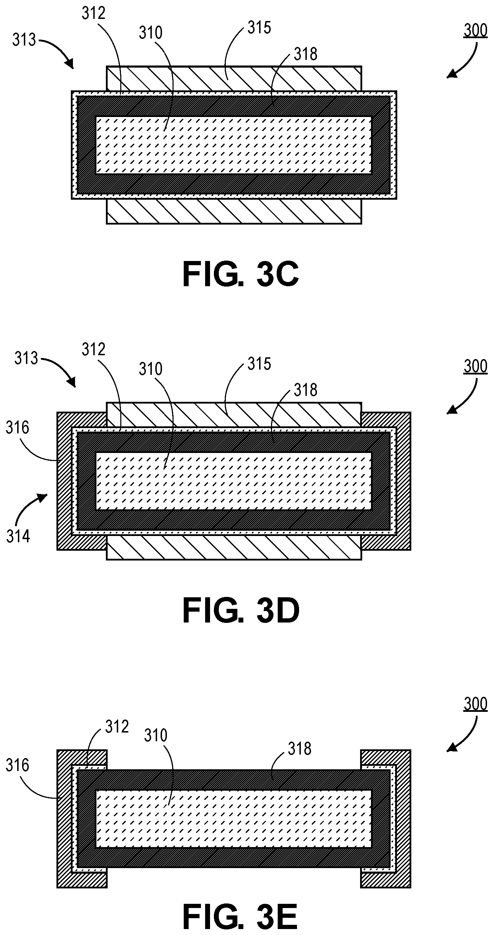

Referring now to Figure 3C, a cross-sectional illustration of the hybrid panel 300 after a resist layer 315 is applied over the seed layer 312 is shown, in accordance with an embodiment. The resist layer 315 may be applied over a top surface and a bottom surface of the glass substrate 310. The resist layer 315 may have a footprint that is smaller than a footprint of the glass substrate 310. As such, outer edge regions 313 of the seed layer 312 remains exposed. In an embodiment, the resist layer 315 may comprise a polymer material, such as polyester or the like. The resist layer 315 may be similar to any of the resist layers described in greater detail herein, and the resist layer 315 may be applied with any suitable process, such as a lamination process or the like.

Referring now to Figure 3D, a cross-sectional illustration of the hybrid panel 300 after a frame 316 is formed on the glass substrate 310 is shown, in accordance with an embodiment. In an embodiment, the frame 316 may be an electrically conductive material, such as a material comprising copper. The frame 316 may be plated from the seed layer 312 with an electroplating process. Since the resist layer 315 blocks portions of the seed layer 312, the frame 316 is selectively formed along the outer edge region 313 of the hybrid panel 300. Further, since the sidewall portions 314 of the seed layer 312 are also exposed, the frame 316 plates up along the sidewall portions 314. Accordingly, the frame 316 comprises a first portion over a top surface of the glass substrate 310, a second portion under a bottom surface of the glass substrate 310, and a third portion along the sidewall surface of the glass substrate 310. In an embodiment, the frame 316 may comprise a C-shaped cross section on one edge of the glass substrate 310 and a backwards C-shaped cross-section on the second edge of the glass substrate 310.

Referring now to Figure 3E, a cross-sectional illustration of the hybrid panel 300 after the resist layer 315 and the seed layer 312 are removed is shown, in accordance with an embodiment. In an embodiment, the resist layer 315 may be removed with any suitable resist stripping process, etching process, or the like. The removal of the resist layer 315 exposes portions of the seed layer 312 between the edges of the frame 316. The seed layer 312 may be removed with an etching process. The removal of the seed layer 312 exposes the buildup layer 318 again. After the buildup layer 318 is exposed, the processing may continue with any typical panel level processing (e.g., via formation through the glass substrate 310, additional buildup layer formation, the formation of electrical routing in the buildup layers, etc.).

As can be appreciated, the depicted in-situ frame 316 formation process allows for perfect alignment between the frame 316 and the glass substrate 310. Additionally, since the frame 316 wraps around the sidewall of the glass substrate 310 (to cover a top surface, a sidewall surface, and a bottom surface), the adhesion between the frame 316 and the glass substrate 310 is improved compared to providing a frame 316 only on the sidewall surface of the glass substrate 310.

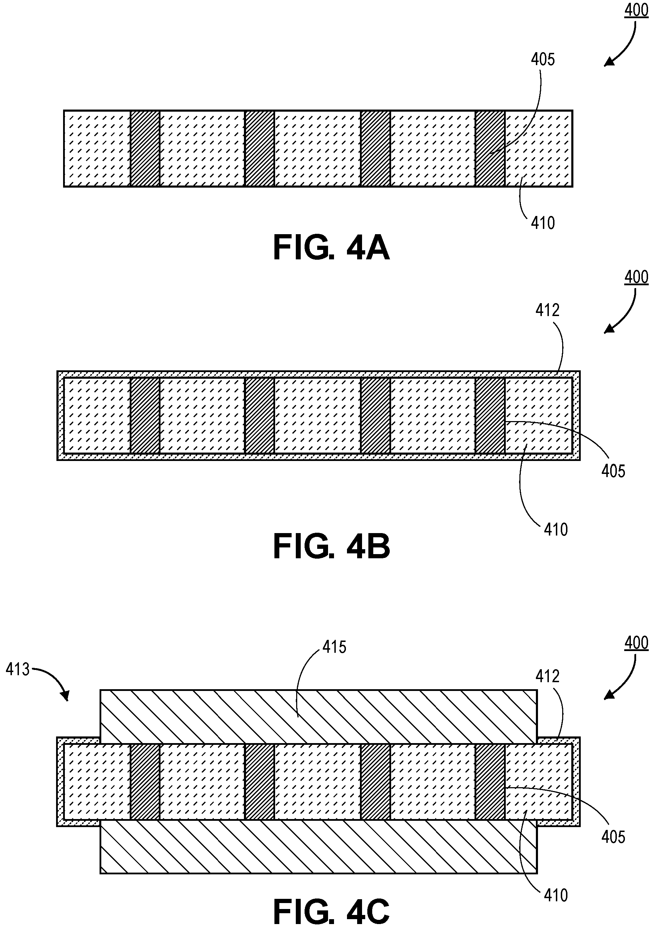

Referring now to Figures 4A - 4H, a series of illustrations depicting a process for forming a hybrid panel 400 is shown, in accordance with an embodiment. The hybrid panel 400 in Figures 4A - 4H is formed with a via 405 first process. That is, the vias 405 through the glass substrate 410 are formed before the frame 416 is applied to the glass substrate 410.

Referring now to Figure 4A, a cross-sectional illustration of the hybrid panel 400 at a stage of manufacture is shown, in accordance with an embodiment. The hybrid panel 400 may comprise a glass substrate 410. The glass substrate 410 may be similar to any of the glass substrates described in greater detail herein. In an embodiment, vias 405 may be formed through a thickness of the glass substrate 410. The vias 405 may be electrically conductive structures, such as copper vias 405. In an embodiment, the vias 405 may be formed with any suitable process. For example, a laser assisted etching process may be used in some embodiments. In the illustrated embodiment, the vias 405 have a substantially rectangular shaped cross-section. In other embodiments, the vias 405 may have tapered sidewalls, or an hourglass shaped cross-section.

Referring now to Figure 4B, a cross-sectional illustration of the hybrid panel 400 after a seed layer 412 is applied over the glass substrate 410 is shown, in accordance with an embodiment. In an embodiment, the seed layer 412 may be similar to any of the seed layers described in greater detail herein. The seed layer 412 may be applied over all exposed surfaces of the glass substrate 410 with any suitable process, such as those described in greater detail herein.

Referring now to Figure 4C, a cross-sectional illustration of the hybrid panel 400 after a resist layer 415 is applied over the seed layer 412 is shown, in accordance with an embodiment. The resist layer 415 may be applied over a top surface and a bottom surface of the glass substrate 410. The resist layer 415 may have a footprint that is smaller than a footprint of the glass substrate 410. As such, outer edge regions 413 of the seed layer 412 remains exposed. In an embodiment, the resist layer 415 may comprise a polymer material, such as polyester or the like. The resist layer 415 may be similar to any of the resist layers described in greater detail herein, and the resist layer 415 may be applied with any suitable process, such as a lamination process or the like.

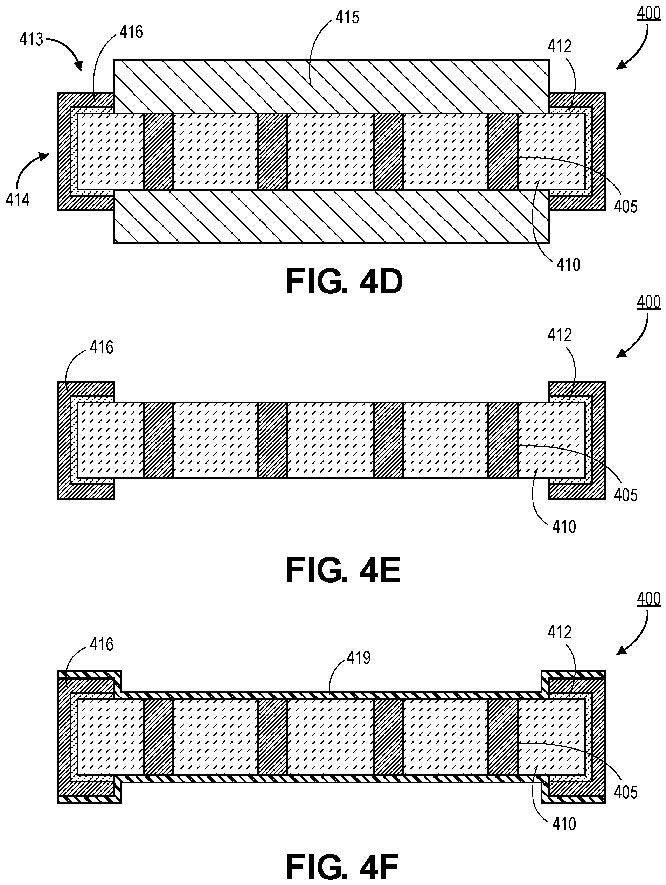

Referring now to Figure 4D, a cross-sectional illustration of the hybrid panel 400 after a frame 416 is formed on the glass substrate 410 is shown, in accordance with an embodiment. In an embodiment, the frame 416 may be an electrically conductive material, such as a material comprising copper. The frame 416 may be plated from the seed layer 412 with an electroplating process. Since the resist layer 415 blocks portions of the seed layer 412, the frame 416 is selectively formed along the outer edge region 413 of the hybrid panel 400. Further, since the sidewall portions 414 of the seed layer 412 are also exposed, the frame 416 plates up along the sidewall portions 414. Accordingly, the frame 416 comprises a first portion over a top surface of the glass substrate 410, a second portion under a bottom surface of the glass substrate 410, and a third portion along the sidewall surface of the glass substrate 410. In an embodiment, the frame 416 may comprise a C-shaped cross section on one edge of the glass substrate 410 and a backwards C-shaped cross-section on the second edge of the glass substrate 410.

Referring now to Figure 4E, a cross-sectional illustration of the hybrid panel 400 after the resist layer 415 is removed is shown, in accordance with an embodiment. In an embodiment, the resist layer 415 may be removed with any suitable resist stripping process, etching process, or the like. The removal of the resist layer 415 exposes portions of the seed layer 412 between the edges of the frame 416. After the resist layer 415 is removed, the exposed portions of the seed layer 412 may be removed with an etching process or the like. The removal of the seed layer 412 exposes the glass substrate 410 again.

Referring now to Figure 4F, a cross-sectional illustration of the hybrid panel 400 after a buffer layer 419 is applied over the top surface and the bottom surface of the hybrid panel 400 is shown, in accordance with an embodiment. In an embodiment, the buffer layer 419 may comprise an organic dielectric material, such as a buildup film. The buffer layer 419 may be applied with a lamination process, and the buffer layer 419 may be provided in contact with the frame 416 and the glass substrate 410. The buffer layer 419 may conform to the shape of the hybrid panel 400. That is, the portion of the buffer layer 419 over the frame 416 may be at a different height than the portion of the buffer layer 419 over the glass substrate 410.

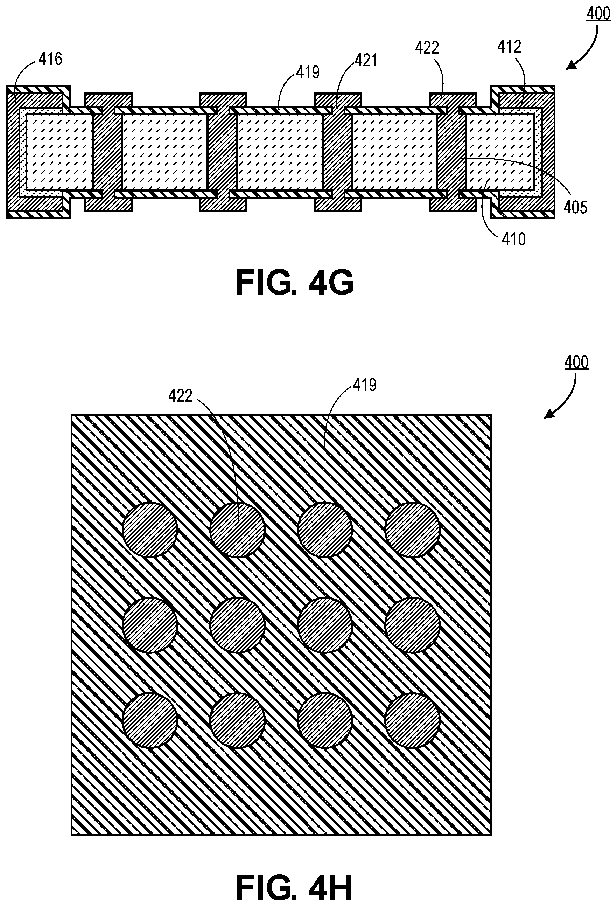

Referring now to Figure 4G, a cross-sectional illustration of the hybrid panel 400 after vias 421 and pads 422 are formed is shown, in accordance with an embodiment. In an embodiment, the vias 421 may be formed with a laser ablation process to form openings through the buffer layer 419. Subsequent processes (e.g., plating, patterning, etc.) may be used in order to form the vias 421 and the pads 422. The vias 421 may electrically couple the pads 422 to the vias 405 in the glass substrate 410.

Referring now to Figure 4H, a plan view illustration of the hybrid panel 400 in Figure 4H is shown, in accordance with an embodiment. As shown, a plurality of pads 422 are distributed across the buffer layer 419. Further, the buffer layer 419 reaches to the edges of the hybrid panel 400 and covers the top (and bottom) portions of the frame 416. Though, as shown in Figure 4G, the sidewall portion of the frame 416 may remain exposed in some embodiments.

As can be appreciated, the depicted in-situ frame 416 formation process allows for perfect alignment between the frame 416 and the glass substrate 410. Additionally, since the frame 416 wraps around the sidewall of the glass substrate 410 (to cover a top surface, a sidewall surface, and a bottom surface), the adhesion between the frame 416 and the glass substrate 410 is improved compared to providing a frame 416 only on the sidewall surface of the glass substrate 410.

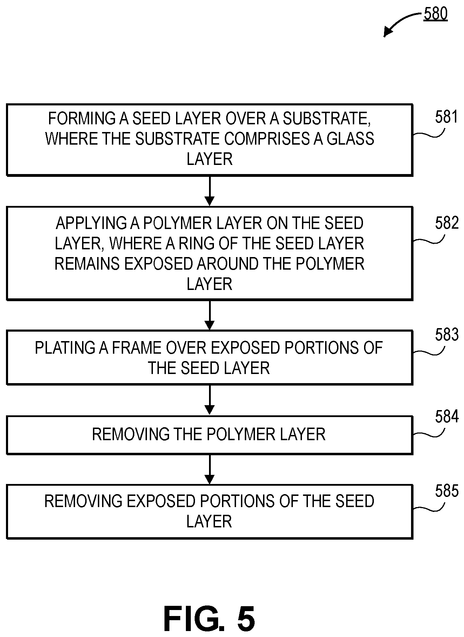

Referring now to Figure 5, a flow diagram of a process 580 for forming a hybrid panel with an in-situ frame fabrication process is shown, in accordance with an embodiment. In an embodiment, the process 580 may be similar to any of the processes used to form hybrid panels 100 - 400 described in greater detail herein.

In an embodiment, the process 580 may begin with operation 581, which comprises forming a seed layer over a substrate, where the substrate comprises a glass layer. In an embodiment, the substrate may be similar to any of the glass substrates described in greater detail herein. The substrate may comprise vias, or the substrate may comprise a continuous solid glass layer. The seed layer may be provided directly on the substrate. Other embodiments may include a buildup layer (with or without an adhesion layer) between the seed layer and the substrate.

In an embodiment, the process 580 may continue with operation 582, which comprises applying a polymer layer on the seed layer, where a ring of the seed layer remains exposed around the polymer layer. The polymer layer may comprise a polyester or the like, and the polymer layer may be applied with a lamination process or the like.

In an embodiment, the process 580 may continue with operation 583, which comprises plating a frame over exposed portions of the seed layer. In an embodiment, the frame may wrap around the edge of the substrate to form a C-shaped profile along each edge. The frame may comprise copper or the like.

In an embodiment, the process 580 may continue with operation 584, which comprises removing the polymer layer. The removal of the polymer layer exposes the seed layer. Operation 585 of the process 580 may continue with removing the exposed portions of the seed layer between the interior edges of the frame.

In the embodiments described in greater detail above, the frames are formed around the perimeter of the glass substrate. In such an embodiment, the resist layer can be substantially any type of polymer since there is no need to pattern the resist layer. However, in some embodiments the frame may comprise a cross member. The cross member may be used in order to define quarter panel regions of the hybrid panel. The generation of such a cross member can be provided when the resist layer is a photoimageable material, such as a photoimageable polymer (PIP).

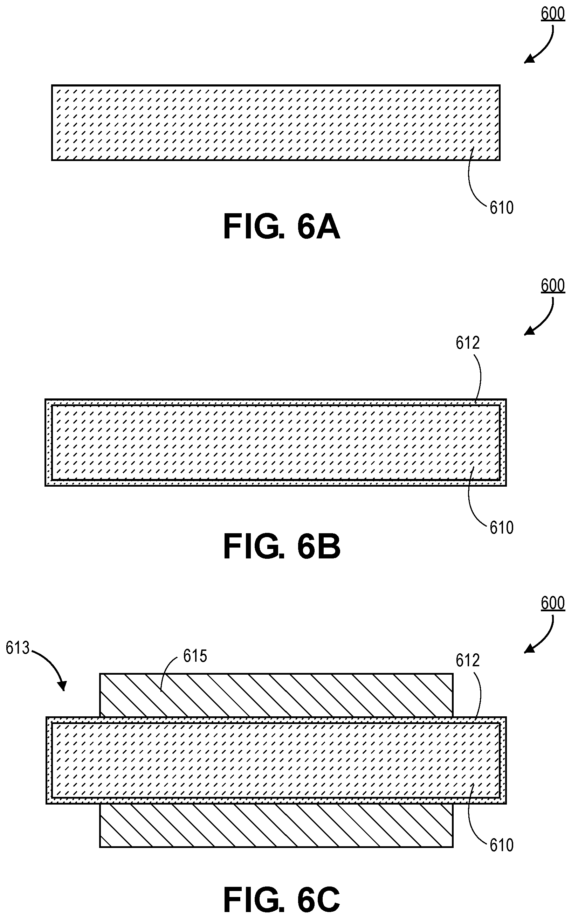

Referring now to Figures 6A - 6H, a series of illustrations depicting a process for forming a hybrid panel 600 with a frame 616 that comprises a cross member 625 over the glass substrate 610 is shown, in accordance with an embodiment.

Referring now to Figure 6A, a cross-sectional illustration of the hybrid panel 600 at a stage of manufacture is shown, in accordance with an embodiment. The hybrid panel 600 may comprise a glass substrate 610. The glass substrate 610 may be similar to any of the glass substrates described in greater detail herein.

Referring now to Figure 6B, a cross-sectional illustration of the hybrid panel 600 after a seed layer 612 is applied over the glass substrate 610 is shown, in accordance with an embodiment. In an embodiment, the seed layer 612 may be similar to any of the seed layers described in greater detail herein. The seed layer 612 may be applied over all exposed surfaces of the glass substrate 610 with any suitable process, such as those described in greater detail herein.

Referring now to Figure 6C, a cross-sectional illustration of the hybrid panel 600 after a resist layer 615 is applied over the seed layer 612 is shown, in accordance with an embodiment. The resist layer 615 may be applied over a top surface and a bottom surface of the glass substrate 610. The resist layer 615 may have a footprint that is smaller than a footprint of the glass substrate 610. As such, outer edge regions 613 of the seed layer 612 remains exposed. In an embodiment, the resist layer 615 may comprise a PIP, such as polyester based PIP or the like. The resist layer 615 may be applied with any suitable process, such as a lamination process or the like.

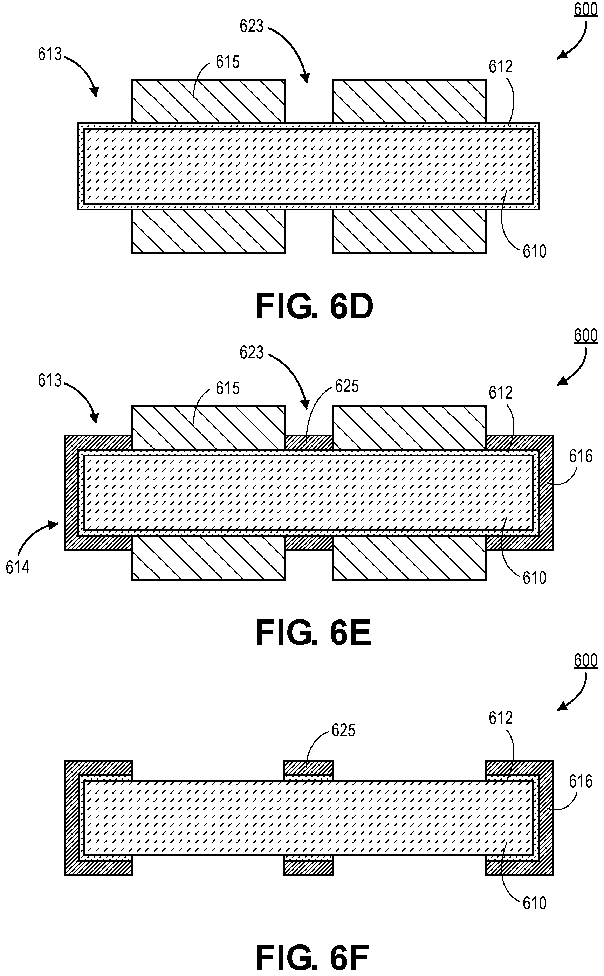

Referring now to Figure 6D, a cross-sectional illustration of the hybrid panel 600 after a pattern 623 is formed into the resist layer 615 is shown, in accordance with an embodiment. The pattern 623 may include one or more openings that section the resist layer 615 into a plurality of regions. For example, the pattern 623 may be a cross that segments the resist layer 615 into quarters (two of which are visible in Figure 6D). The resist layer 615 may be patterned with any suitable patterning process, such as a selective lithographic exposure and developing process.

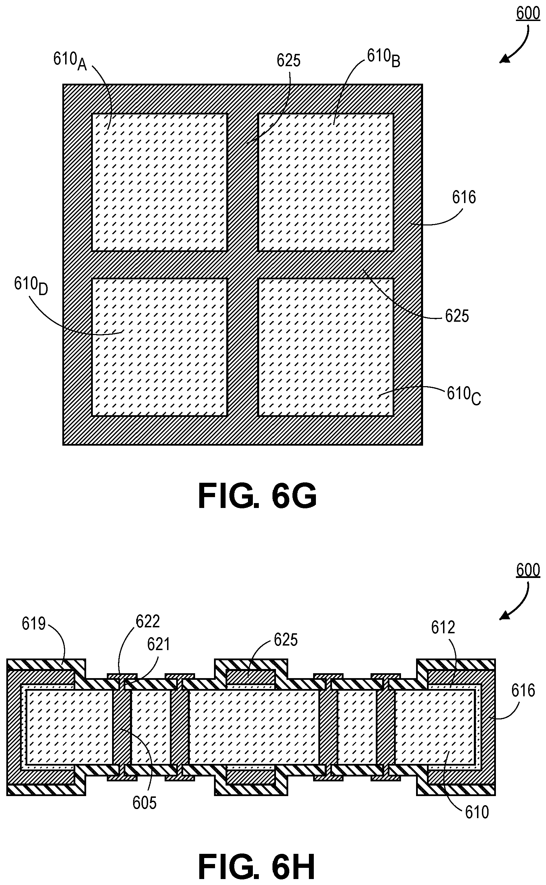

Referring now to Figure 6E, a cross-sectional illustration of the hybrid panel 600 after a frame 616 is formed on the glass substrate 610 is shown, in accordance with an embodiment. In an embodiment, the frame 616 may be an electrically conductive material, such as a material comprising copper. The frame 616 may also comprise a cross member 625 that is plated up from the seed layer 612 exposed by the pattern 623. The cross member 625 may be directly coupled to a portion of the outer region of the frame 616 (which out of the plane of Figure 6E), as will be illustrated in greater detail in Figure 6G.

In an embodiment, the frame 616 and the cross member 625 may be plated from the seed layer 612 with an electroplating process. Since the resist layer 615 blocks portions of the seed layer 612, the frame 616 is selectively formed along the outer edge region 613 of the hybrid panel 600 and along the pattern 623 across a surface of the hybrid panel 600. Further, since the sidewall portions 614 of the seed layer 612 are also exposed, the frame 616 plates up along the sidewall portions 614. Accordingly, the frame 616 comprises a first portion over a top surface of the glass substrate 610, a second portion under a bottom surface of the glass substrate 610, and a third portion along the sidewall surface of the glass substrate 610. In an embodiment, the frame 616 may comprise a C-shaped cross section on one edge of the glass substrate 610 and a backwards C-shaped cross-section on the second edge of the glass substrate 610.

Referring now to Figure 6F, a cross-sectional illustration of the hybrid panel 600 after the resist layer 615 and exposed portions of the seed layer 612 are removed is shown, in accordance with an embodiment. In an embodiment, the resist layer 615 may be removed with any suitable resist stripping process, etching process, or the like. The removal of the resist layer 615 exposes portions of the seed layer 612 between the edges of the frame 616 and the cross member 625. The seed layer 612 may be removed with an etching process. The removal of the seed layer 612 exposes the glass substrate 610 again.

Referring now to Figure 6G, a plan view illustration of the hybrid panel 600 in Figure 6F is shown, in accordance with an embodiment. As shown, the frame 616 comprises a cross member 625 that divides the glass substrate 610 into a plurality of regions 610_{A}- 610_{D}. This may be suitable for subsequent quarter panel processing and/or singulation. The cross member 625 may also include a single trace across the hybrid panel 600 (i.e., to divide the glass substrate 610 in half), or the cross member 625 may have any number of traces in order to form any arbitrary number of glass substrate 610 regions (e.g., including a region for each individual unit).

Referring now to Figure 6H, a cross-sectional illustration of the hybrid panel 600 after vias 605 are formed into the glass substrate 610, and a buffer layer 619 with pads 622 and vias 621 is formed over the top surface and the bottom surface of the hybrid panel 600 is shown, in accordance with an embodiment. The vias 605 may be formed with any suitable process, such as those described in greater detail herein. In an embodiment, the buffer layer 619 may comprise an organic dielectric material, such as a buildup film. The buffer layer 619 may be applied with a lamination process, and the buffer layer 619 may be provided in contact with the frame 616 and the glass substrate 610. The buffer layer 619 may conform to the shape of the hybrid panel 600. That is, the portion of the buffer layer 619 over the frame 616 may be at a different height than the portion of the buffer layer 619 over the glass substrate 610.

In an embodiment, the vias 621 may be formed with a laser ablation process to form openings through the buffer layer 619. Subsequent processes (e.g., plating, patterning, etc.) may be used in order to form the vias 621 and the pads 622. The vias 621 may electrically couple the pads 622 to the vias 605 in the glass substrate 610. As shown, the plurality of pads 622 are distributed across the buffer layer 619 between the frame 616 and the cross member 625. Further, the buffer layer 619 reaches to the edges of the hybrid panel 600 and covers the top (and bottom) portions of the frame 616 and the cross member 625. Though, the sidewall portion of the frame 616 may remain exposed in some embodiments.

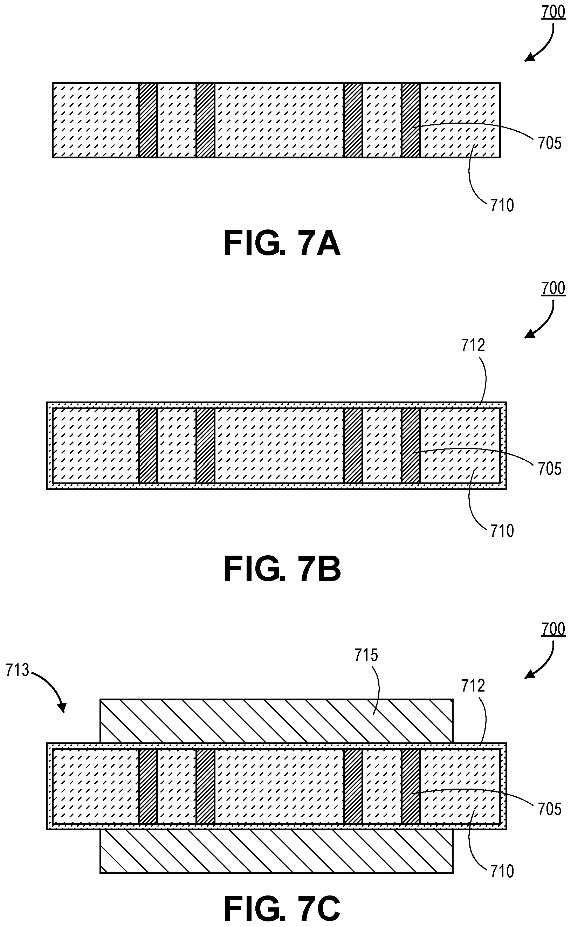

Referring now to Figures 7A - 7H, a series of illustrations depicting a process for forming a hybrid panel 700 with a frame 716 that comprises a cross member 725 over the glass substrate 710 using a via first process is shown, in accordance with an embodiment.

Referring now to Figure 7A, a cross-sectional illustration of the hybrid panel 700 at a stage of manufacture is shown, in accordance with an embodiment. The hybrid panel 700 may comprise a glass substrate 710. The glass substrate 710 may be similar to any of the glass substrates described in greater detail herein. In an embodiment, vias 705 may be formed through a thickness of the glass substrate 710 with any suitable process, such as those described in greater detail herein. In an embodiment, the vias 705 may have rectangular cross-sectional shapes, hourglass cross-sectional shapes, or the like. The sidewalls of the vias 705 may be tapered in some embodiments.

Referring now to Figure 7B, a cross-sectional illustration of the hybrid panel 700 after a seed layer 712 is applied over the glass substrate 710 is shown, in accordance with an embodiment. In an embodiment, the seed layer 712 may be similar to any of the seed layers described in greater detail herein. The seed layer 712 may be applied over all exposed surfaces of the glass substrate 710 with any suitable process, such as those described in greater detail herein.

Referring now to Figure 7C, a cross-sectional illustration of the hybrid panel 700 after a resist layer 715 is applied over the seed layer 712 is shown, in accordance with an embodiment. The resist layer 715 may be applied over a top surface and a bottom surface of the glass substrate 710. The resist layer 715 may have a footprint that is smaller than a footprint of the glass substrate 710. As such, outer edge regions 713 of the seed layer 712 remains exposed. In an embodiment, the resist layer 715 may comprise a PIP, such as polyester based PIP or the like. The resist layer 715 may be applied with any suitable process, such as a lamination process or the like.

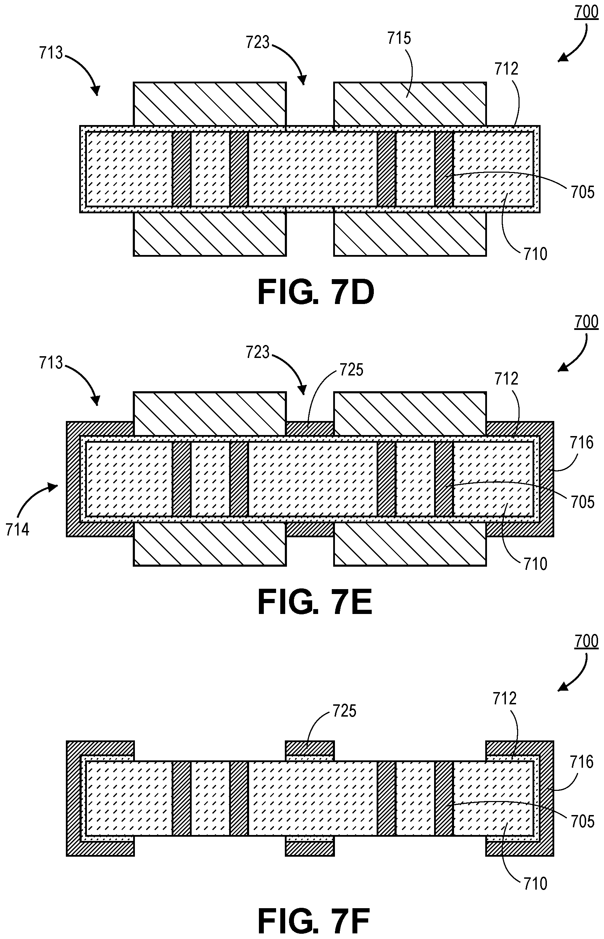

Referring now to Figure 7D, a cross-sectional illustration of the hybrid panel 700 after a pattern 723 is formed into the resist layer 715 is shown, in accordance with an embodiment. The pattern 723 may be a cross member that sections the resist layer 715 into a plurality of regions. For example, the pattern 723 may be a cross that segments the resist layer 715 into quarters (two of which are visible in Figure 7D). The resist layer 715 may be patterned with any suitable patterning process, such as a selective lithographic exposure and developing process.

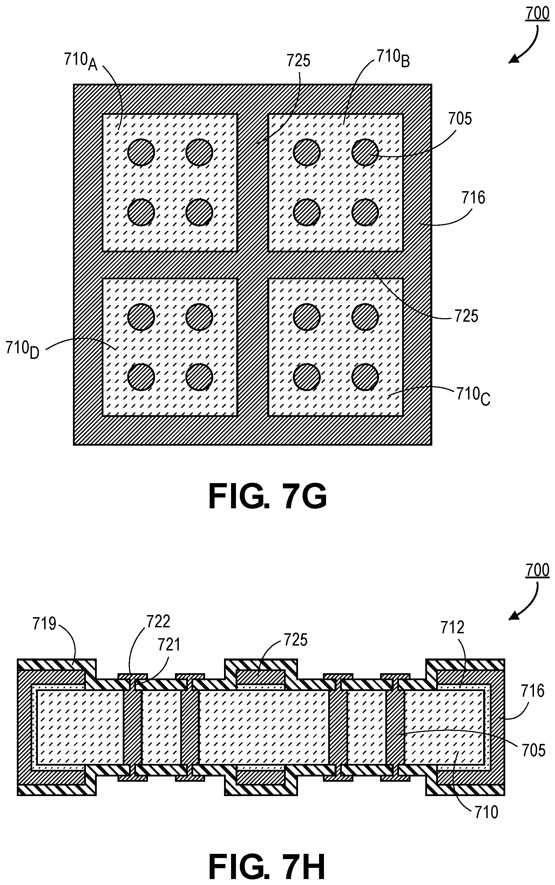

Referring now to Figure 7E, a cross-sectional illustration of the hybrid panel 700 after a frame 716 is formed on the glass substrate 710 is shown, in accordance with an embodiment. In an embodiment, the frame 716 may be an electrically conductive material, such as a material comprising copper. The frame 716 may also comprise a cross member 725 that is plated up from the seed layer 712 exposed by the pattern 723. The cross member 725 may be directly coupled to a portion of the outer region of the frame 716 (which out of the plane of Figure 7E), as will be illustrated in greater detail in Figure 7G.

In an embodiment, the frame 716 and the cross member 725 may be plated from the seed layer 712 with an electroplating process. Since the resist layer 715 blocks portions of the seed layer 712, the frame 716 is selectively formed along the outer edge region 713 of the hybrid panel 700 and along the pattern 723 across a surface of the hybrid panel 700. Further, since the sidewall portions 714 of the seed layer 712 are also exposed, the frame 716 plates up along the sidewall portions 714. Accordingly, the frame 716 comprises a first portion over a top surface of the glass substrate 710, a second portion under a bottom surface of the glass substrate 710, and a third portion along the sidewall surface of the glass substrate 710. In an embodiment, the frame 716 may comprise a C-shaped cross section on one edge of the glass substrate 710 and a backwards C-shaped cross-section on the second edge of the glass substrate 710.

Referring now to Figure 7F, a cross-sectional illustration of the hybrid panel 700 after the resist layer 715 and exposed portions of the seed layer 712 are removed is shown, in accordance with an embodiment. In an embodiment, the resist layer 715 may be removed with any suitable resist stripping process, etching process, or the like. The removal of the resist layer 715 exposes portions of the seed layer 712 between the edges of the frame 716 and the cross member 725. The seed layer 712 may be removed with an etching process. The removal of the seed layer 712 exposes the glass substrate 710 again.

Referring now to Figure 7G, a plan view illustration of the hybrid panel 700 in Figure 7F is shown, in accordance with an embodiment. As shown, the frame 716 comprises a cross member 725 that divides the glass substrate 710 into a plurality of regions 710_{A} - 710_{D}. This may be suitable for subsequent quarter panel processing and/or singulation. The cross member 725 may also include a single trace across the hybrid panel 700 (i.e., to divide the glass substrate 710 in half), or the cross member 725 may have any number of traces in order to form any arbitrary number of glass substrate 710 regions (e.g., including a region for each individual unit).

Referring now to Figure 7H, a cross-sectional illustration of the hybrid panel 700 after a buffer layer 719 with pads 722 and vias 721 are formed over the top surface and the bottom surface of the hybrid panel 700 is shown, in accordance with an embodiment. In an embodiment, the buffer layer 719 may comprise an organic dielectric material, such as a buildup film. The buffer layer 719 may be applied with a lamination process, and the buffer layer 719 may be provided in contact with the frame 716 and the glass substrate 710. The buffer layer 719 may conform to the shape of the hybrid panel 700. That is, the portion of the buffer layer 719 over the frame 716 may be at a different height than the portion of the buffer layer 719 over the glass substrate 710.

In an embodiment, the vias 721 may be formed with a laser ablation process to form openings through the buffer layer 719. Subsequent processes (e.g., plating, patterning, etc.) may be used in order to form the vias 721 and the pads 722. The vias 721 may electrically couple the pads 722 to the vias 705 in the glass substrate 710. As shown, the plurality of pads 722 are distributed across the buffer layer 719 between the frame 716 and the cross member 725. Further, the buffer layer 719 reaches to the edges of the hybrid panel 700 and covers the top (and bottom) portions of the frame 716 and the cross member 725. Though, the sidewall portion of the frame 716 may remain exposed in some embodiments.

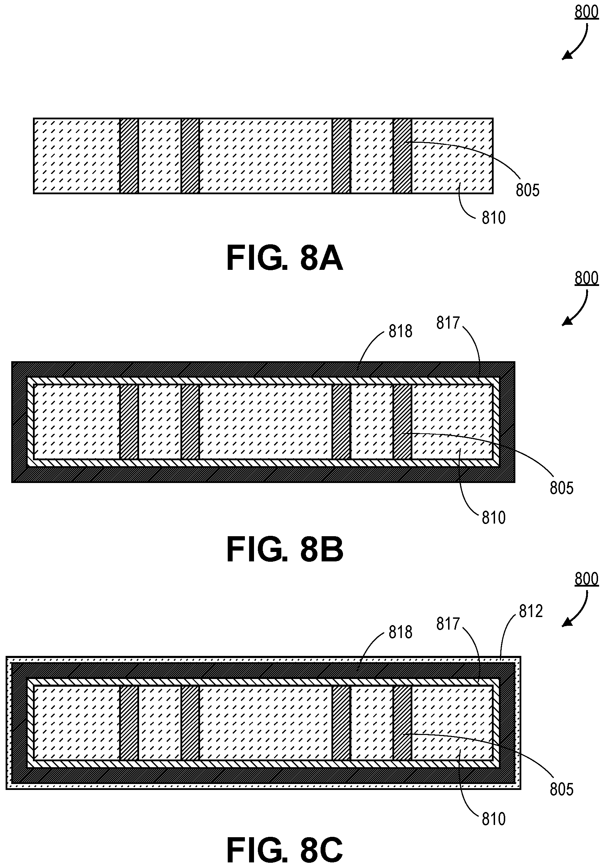

Referring now to Figures 8A - 8I, a series of illustrations depicting a process for forming a hybrid panel 800 with a frame 816 that comprises a cross member 825 over the glass substrate 810 using a via first process is shown, in accordance with an embodiment.

Referring now to Figure 8A, a cross-sectional illustration of the hybrid panel 800 at a stage of manufacture is shown, in accordance with an embodiment. The hybrid panel 800 may comprise a glass substrate 810. The glass substrate 810 may be similar to any of the glass substrates described in greater detail herein. In an embodiment, vias 805 may be formed through a thickness of the glass substrate 810 with any suitable process, such as those described in greater detail herein. In an embodiment, the vias 805 may have rectangular cross-sectional shapes, hourglass cross-sectional shapes, or the like. The sidewalls of the vias 805 may be tapered in some embodiments.

Referring now to Figure 8B, a cross-sectional illustration of the hybrid panel 800 after a buildup layer 818 and an adhesion layer 817 are formed over the glass substrate 810. In an embodiment, the buildup layer 818 is applied over the surfaces of the glass substrate 810. The buildup layer 818 may be on the top surface, the bottom surface, and sidewall surfaces of the glass substrate 810. The buildup layer 818 may comprise an organic dielectric material, such as a traditional buildup film material used in electronics packaging applications. In an embodiment, the buildup layer 818 may be separated from the glass substrate 810 by an adhesion layer 817. The adhesion layer 817 may be a material that is tuned to improve adhesion strength between the buildup layer 818 and the glass substrate 810. In some instances, the adhesion layer 817 is an inorganic material, such as silicon nitride or the like. Though, in some embodiments, the adhesion layer 817 may be omitted, and the buildup layer 818 may be formed directly on the glass substrate 810.

Referring now to Figure 8C, a cross-sectional illustration of the hybrid panel 800 after a seed layer 812 is applied over the buildup layer 818 is shown, in accordance with an embodiment. In an embodiment, the seed layer 812 may be similar to any of the seed layers described in greater detail herein. The seed layer 812 may be applied over all exposed surfaces of the buildup layer 818 with any suitable process, such as those described in greater detail herein.

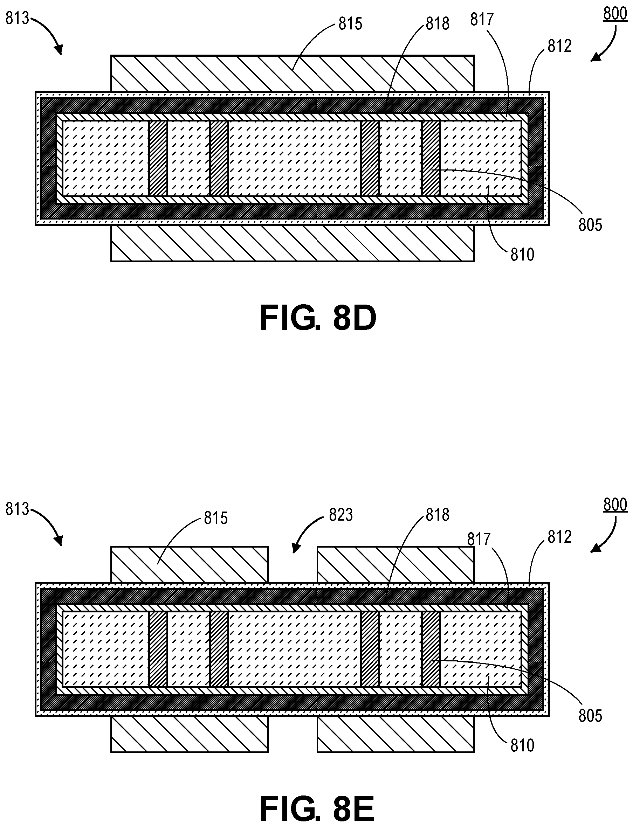

Referring now to Figure 8D, a cross-sectional illustration of the hybrid panel 800 after a resist layer 815 is applied over the seed layer 812 is shown, in accordance with an embodiment. The resist layer 815 may be applied over a top surface and a bottom surface of the glass substrate 810. The resist layer 815 may have a footprint that is smaller than a footprint of the glass substrate 810. As such, outer edge regions 813 of the seed layer 812 remains exposed. In an embodiment, the resist layer 815 may comprise a PIP, such as polyester based PIP or the like. The resist layer 815 may be applied with any suitable process, such as a lamination process or the like.

Referring now to Figure 8E, a cross-sectional illustration of the hybrid panel 800 after a pattern 823 is formed into the resist layer 815 is shown, in accordance with an embodiment. The pattern 823 may be a cross member that sections the resist layer 815 into a plurality of regions. For example, the pattern 823 may be a cross that segments the resist layer 815 into quarters (two of which are visible in Figure 8D). The resist layer 815 may be patterned with any suitable patterning process, such as a selective lithographic exposure and developing process.

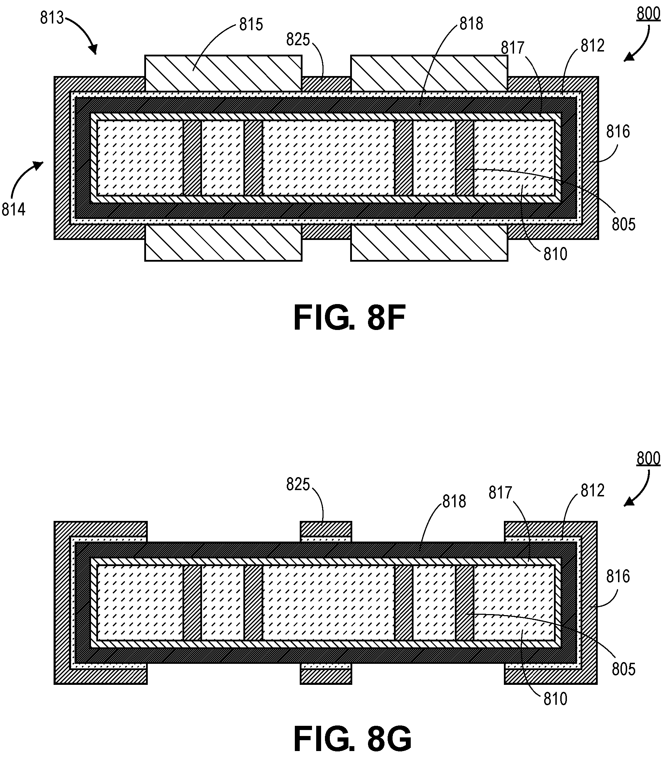

Referring now to Figure 8F, a cross-sectional illustration of the hybrid panel 800 after a frame 816 is formed on the glass substrate 810 is shown, in accordance with an embodiment. In an embodiment, the frame 816 may be an electrically conductive material, such as a material comprising copper. The frame 816 may also comprise a cross member 825 that is plated up from the seed layer 812 exposed by the pattern 823. The cross member 825 may be directly coupled to a portion of the outer region of the frame 816 (which out of the plane of Figure 8E), as will be illustrated in greater detail in Figure 8G.

In an embodiment, the frame 816 and the cross member 825 may be plated from the seed layer 812 with an electroplating process. Since the resist layer 815 blocks portions of the seed layer 812, the frame 816 is selectively formed along the outer edge region 813 of the hybrid panel 800 and along the pattern 823 across a surface of the hybrid panel 800. Further, since the sidewall portions 814 of the seed layer 812 are also exposed, the frame 816 plates up along the sidewall portions 814. Accordingly, the frame 816 comprises a first portion over a top surface of the glass substrate 810, a second portion under a bottom surface of the glass substrate 810, and a third portion along the sidewall surface of the glass substrate 810. In an embodiment, the frame 816 may comprise a C-shaped cross section on one edge of the glass substrate 810 and a backwards C-shaped cross-section on the second edge of the glass substrate 810.

Referring now to Figure 8G, a cross-sectional illustration of the hybrid panel 800 after the resist layer 815 and exposed portions of the seed layer 812 are removed is shown, in accordance with an embodiment. In an embodiment, the resist layer 815 may be removed with any suitable resist stripping process, etching process, or the like. The removal of the resist layer 815 exposes portions of the seed layer 812 between the edges of the frame 816 and the cross member 825. The seed layer 812 may be removed with an etching process. The removal of the seed layer 812 exposes the buildup layer 818 again.

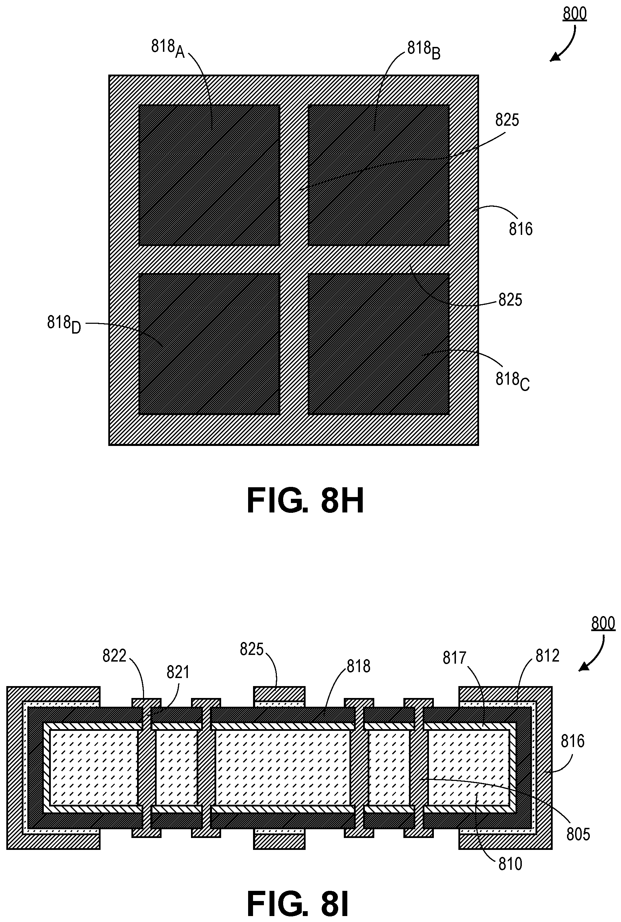

Referring now to Figure 8H, a plan view illustration of the hybrid panel 800 in Figure 8G is shown, in accordance with an embodiment. As shown, the frame 816 comprises a cross member 825 that divides the buildup layer 818 into a plurality of regions 818_{A} - 818_{D}. This may be suitable for subsequent quarter panel processing and/or singulation. The cross member 825 may also include a single trace across the hybrid panel 800 (i.e., to divide the glass substrate 810 in half), or the cross member 825 may have any number of traces in order to form any arbitrary number of glass substrate 810 regions (e.g., including a region for each individual unit).

Referring now to Figure 8I, a cross-sectional illustration of the hybrid panel 800 after pads 822 and vias 821 are formed over the top surface and the bottom surface of the hybrid panel 800 is shown, in accordance with an embodiment. In an embodiment, the vias 821 may be formed with a laser ablation process to form openings through the buildup layer 818. Subsequent processes (e.g., plating, patterning, etc.) may be used in order to form the vias 821 and the pads 822. The vias 821 may electrically couple the pads 822 to the vias 805 in the glass substrate 810. As shown, the plurality of pads 822 are distributed across the buildup layer 818 between the frame 816 and the cross member 825.

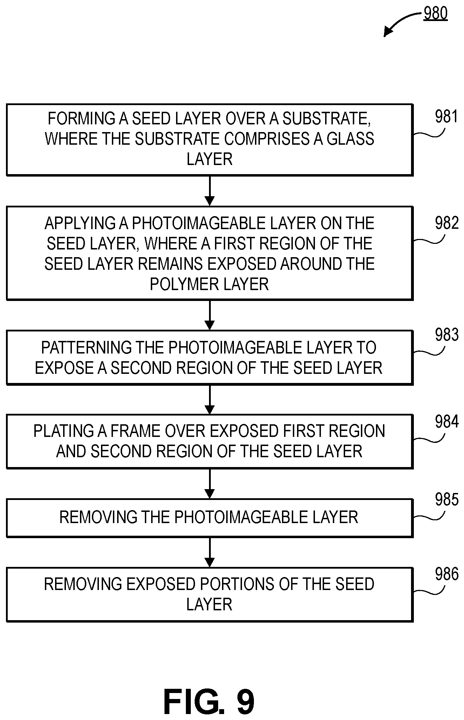

Referring now to Figure 9, a flow diagram of a process for forming a hybrid panel with a frame and cross member with an in-situ process is shown, in accordance with an embodiment. In an embodiment, the process 980 may be similar to any of the processes used to form hybrid panels 600 - 800 described in greater detail herein.

In an embodiment, the process 980 may begin with operation 981, which comprises forming a seed layer over a substrate, where the substrate comprises a glass layer. In an embodiment, the substrate may be similar to any of the glass substrates described in greater detail herein. The substrate may comprise vias, or the substrate may comprise a continuous solid glass layer. The seed layer may be provided directly on the substrate. Other embodiments may include a buildup layer (with or without an adhesion layer) between the seed layer and the substrate.

In an embodiment, the process 980 may continue with operation 982, which comprises applying a PIP layer on the seed layer, where a first region of the seed layer remains exposed around the PIP. The first region may be a ring around the PIP layer. The PIP layer may comprise a polyester based material or the like, and the PIP layer may be applied with a lamination process or the like.

In an embodiment, the process 980 may continue with operation 983, which comprises patterning the PIP layer to expose a second region of the seed layer. The second region of the seed layer may segment the PIP layer into two or more distinct regions, such as quarter panel regions. The PIP layer may be patterned with selective exposure of the PIP layer that is followed by a developing process or the like.

In an embodiment, the process 980 may continue with operation 984, which comprises plating a frame and cross member over exposed first region and second region of the seed layer. In an embodiment, the frame may wrap around the edge of the substrate to form a C-shaped profile along each edge. The frame may comprise copper or the like.

In an embodiment, the process 980 may continue with operation 985, which comprises removing the PIP layer. The removal of the PIP layer exposes the seed layer. Operation 986 of the process 980 may continue with removing the exposed portions of the seed layer between the interior edges of the frame.

In the embodiments described in greater detail above, the hybrid panels include frames that wrap around the edges of the glass substrate. However, embodiments may also comprise frames that include dummy vias that pass through a thickness of the glass substrate. The dummy vias may mechanically couple the top portion of the frame to the bottom portion of the frame. These dummy vias may improve the mechanical reliability of the hybrid panel since the frame is physically anchored to the glass substrate.

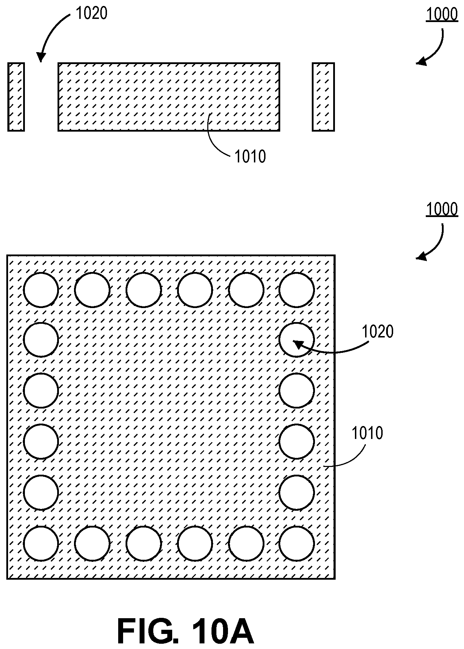

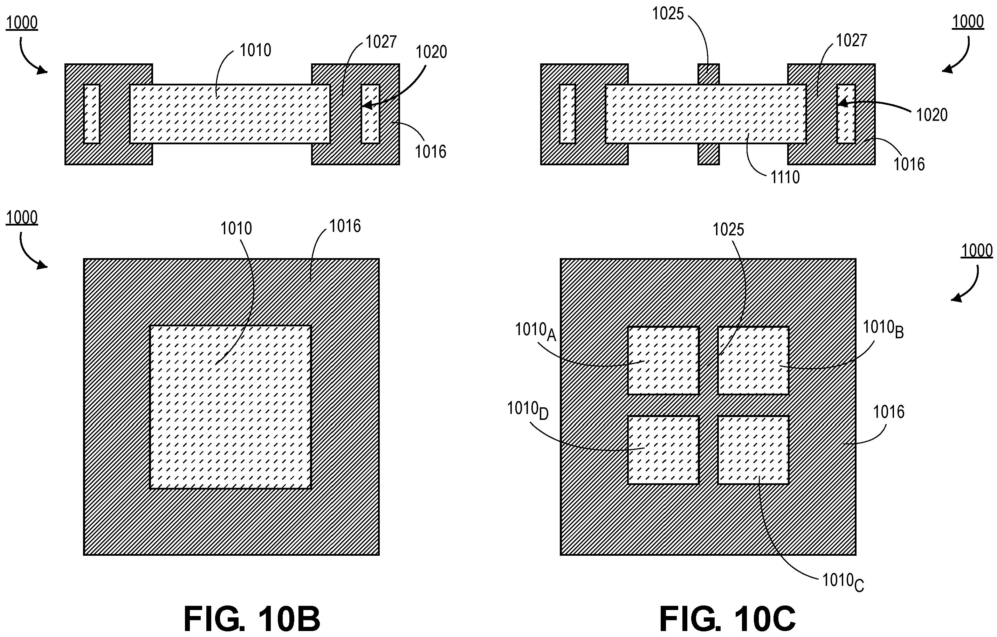

Referring now to Figures 10A - 10C, a series of illustrations showing a hybrid panel 1000 before frame plating (Figure 10A) and after frame plating (Figures 10B and 10C) is shown, in accordance with different embodiments. In Figures 10A - 10C, the bottom drawing is a plan view and the top drawing is a corresponding cross-sectional illustration.

Referring now to Figure 10A, a plan view illustration and a corresponding cross-sectional illustration of a hybrid panel 1000 at a stage of manufacture are shown, in accordance with an embodiment. The hybrid panel 1000 may comprise a glass substrate 1010. The glass substrate 1010 may be similar to any of the glass substrates described in greater detail herein. In an embodiment, a plurality of holes 1020 may be formed through a thickness of the glass substrate 1010. In the illustrated embodiment, the plurality of holes 1020 are arranged in a ring pattern proximate to an edge of the glass substrate 1010. Though, the holes 1020 may be provided with any pattern along the edges of the glass substrate 1010. In the illustrated embodiment, the holes 1020 have substantially vertical sidewalls. Though, in other embodiments, the holes 1020 may have tapered sidewalls. The holes 1020 may have an hourglass shaped cross-sectional profile in some embodiments. The holes 1020 may be formed with any suitable patterning process, such as a laser assisted patterning process.

Referring now to Figure 10B, a plan view illustration and a corresponding cross-sectional illustration of the hybrid panel 1000 after a frame 1016 is formed are shown, in accordance with an embodiment. The frame 1016 may be formed with any patterning and plating process. For example, a seed layer (not shown) may be deposited over the surfaces of the glass substrate 1010, and a polymer layer may be applied over the top and bottom surfaces of the glass substrate 1010. An electroplating process is then used to plate up the frame 1016. The frame 1016 may also comprise dummy vias 1027 that fill the holes 1020.

Referring now to Figure 10C, a plan view illustration and a corresponding cross-sectional illustration of the hybrid panel 1000 after a frame 1016 with a cross member 1025 is formed is shown, in accordance with an embodiment. The process for forming the frame 1016 with the cross member 1025 may be similar to the one described with respect to Figure 10B, with the exception of the resist layer. For example, a PIP may be used so that a patterned opening across the glass substrate 1010 is formed in order to plate up the cross member 1025 in addition to the frame 1016. The cross member 1025 may divide the glass substrate 1010 into a plurality of regions 1010_{A} - 1010_{B}.

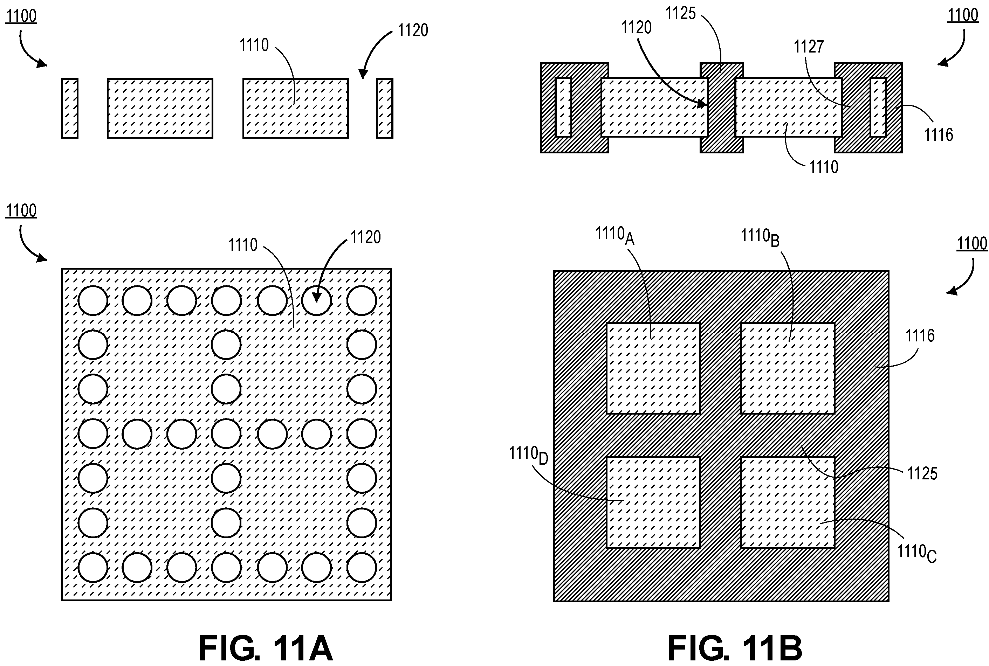

Referring now to Figures 11A and 11B, a series of illustrations showing a hybrid panel 1000 before frame plating (Figure 11A) and after frame plating (Figure 11B) is shown, in accordance with different embodiments. In Figures 11A - 11B, the bottom drawing is a plan view and the top drawing is a corresponding cross-sectional illustration.

Referring now to Figure 11A, a plan view illustration and a corresponding cross-sectional illustration of a hybrid panel 1100 at a stage of manufacture are shown, in accordance with an embodiment. The hybrid panel 1100 may comprise a glass substrate 1110. The glass substrate 1110 may be similar to any of the glass substrates described in greater detail herein. In an embodiment, a plurality of holes 1120 may be formed through a thickness of the glass substrate 1110. In the illustrated embodiment, the plurality of holes 1120 are arranged in a ring pattern proximate to an edge of the glass substrate 1110. Additionally, a series of holes 1120 may be formed across the glass substrate 1110 in a cross pattern. The holes 1120 may be similar to the holes 1020 described in greater detail herein.

Referring now to Figure 11B, a plan view illustration and a corresponding cross-sectional illustration of the hybrid panel 1100 after a frame 1116 is formed are shown, in accordance with an embodiment. The frame 1116 may be formed with any patterning and plating process. For example, a seed layer (not shown) may be deposited over the surfaces of the glass substrate 1110, and a PIP layer may be applied over the top and bottom surfaces of the glass substrate 1110. The PIP layer may be patterned to form a pattern to allow for the formation of a cross member 1125. An electroplating process is then used to plate up the frame 1116 and the cross member 1125. The cross member 1125 may divide the glass substrate 1110 into a plurality of regions 1110_{A} - 1110_{D}. The frame 1116 and the cross member 1125 may also comprise dummy vias 1127 that fill the holes 1120.

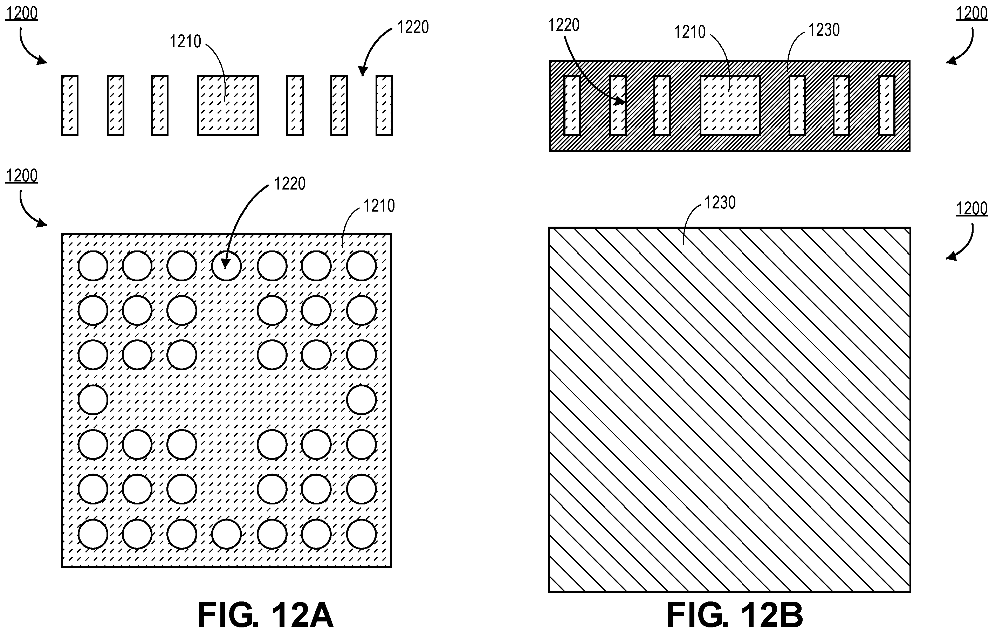

Referring now to Figures 12A - 12G a series of illustrations depicting a process for forming a hybrid panel 1200 with a frame 1216 that includes dummy vias 1227 is shown, in accordance with an embodiment. In Figures 12A - 12G, the bottom drawing is a plan view and the top drawing is a corresponding cross-sectional illustration.

Referring now to Figure 12A, a plan view illustrations and a corresponding cross-sectional illustration of a hybrid panel 1200 at a stage of manufacture are shown, in accordance with an embodiment. The hybrid panel 1200 may comprise a glass substrate 1210. The glass substrate 1210 may be similar to any of the glass substrates described in greater detail herein. In an embodiment, a plurality of holes 1220 may be formed through a thickness of the glass substrate 1210. In the illustrated embodiment, the plurality of holes 1220 are arranged in a ring pattern proximate to an edge of the glass substrate 1210. Additionally, a series of holes 1220 may be formed across the glass substrate 1210 in a cross pattern. The holes 1220 may be similar to the holes 1020 described in greater detail herein. In an embodiment, holes 1220 may also be included for the formation of standard through glass vias used for electrical routing.

Referring now to Figure 12B, a plan view illustration and a corresponding cross-sectional illustration of the hybrid panel 1200 after a metal layer 1230 is plated over the glass substrate 1210 are shown, in accordance with an embodiment. In an embodiment, the metal layer 1230 may comprise copper or the like. The metal layer 1230 may be plated up from a seed layer (not shown) that is deposited over all of the exposed surfaces of the glass substrate 1210.

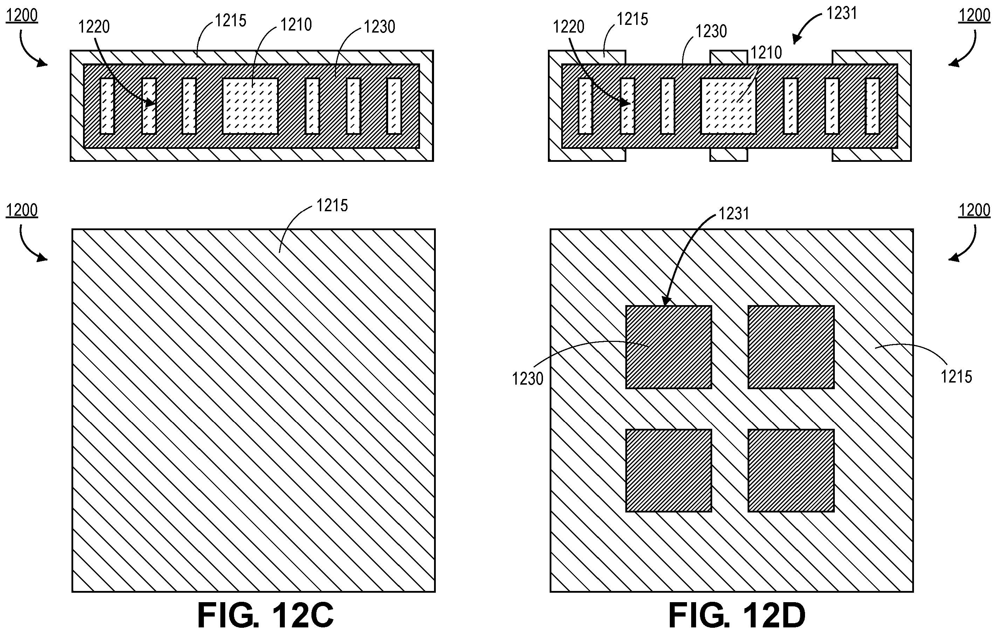

Referring now to Figure 12C, a plan view illustration and a corresponding cross-sectional illustration of the hybrid panel 1200 after a resist layer 1215 is formed over the metal layer 1230 is shown, in accordance with an embodiment. The resist layer 1215 may be a PIP layer or any other suitable photoimageable resist material.

Referring now to Figure 12D, a plan view illustration and a corresponding cross-sectional illustration of the hybrid panel 1200 after the resist layer 1215 is patterned are shown, in accordance with an embodiment. In an embodiment, openings 1231 may be patterned into the resist layer 1215 in order to expose portions of the metal layer 1230. The openings 1231 may be formed with an exposure and developing process.

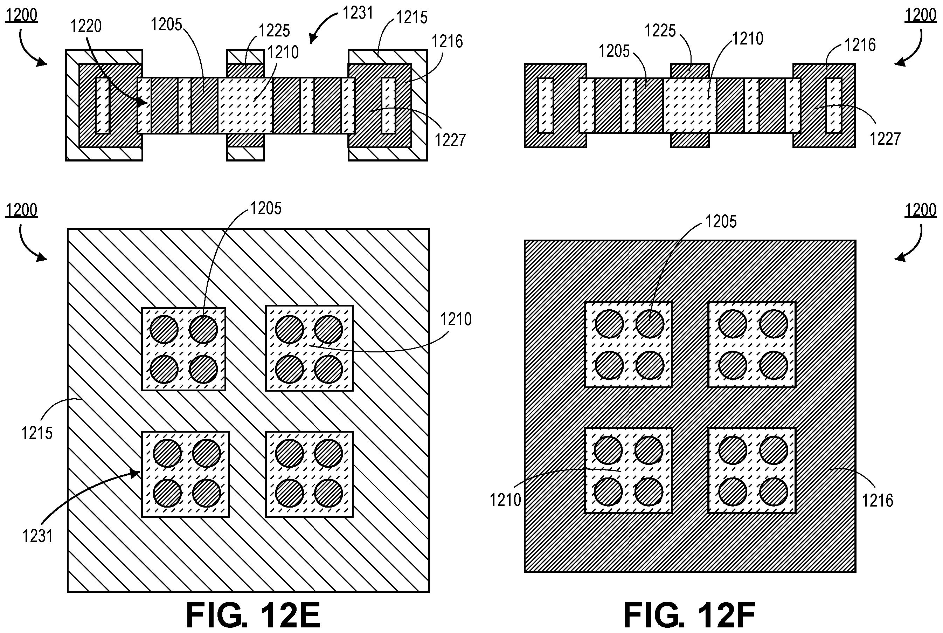

Referring now to Figure 12E, a plan view illustration and a corresponding cross-sectional illustration of the hybrid panel 1200 after portions of the metal layer 1230 are etched back in order to define the metal frame 1216 and cross member 1225 are shown, in accordance with an embodiment. In an embodiment, the metal frame 1216 may comprise dummy vias 1227 to improve the mechanical coupling of the metal frame 1216 to the glass substrate 1210. Removal of portions of the metal layer 1230 also defines the vias 1205 through the glass substrate 1210.

Referring now to Figure 12F, a plan view illustration and a corresponding cross-sectional illustration of the hybrid panel 1200 after the resist layer is removed are shown, in accordance with an embodiment.

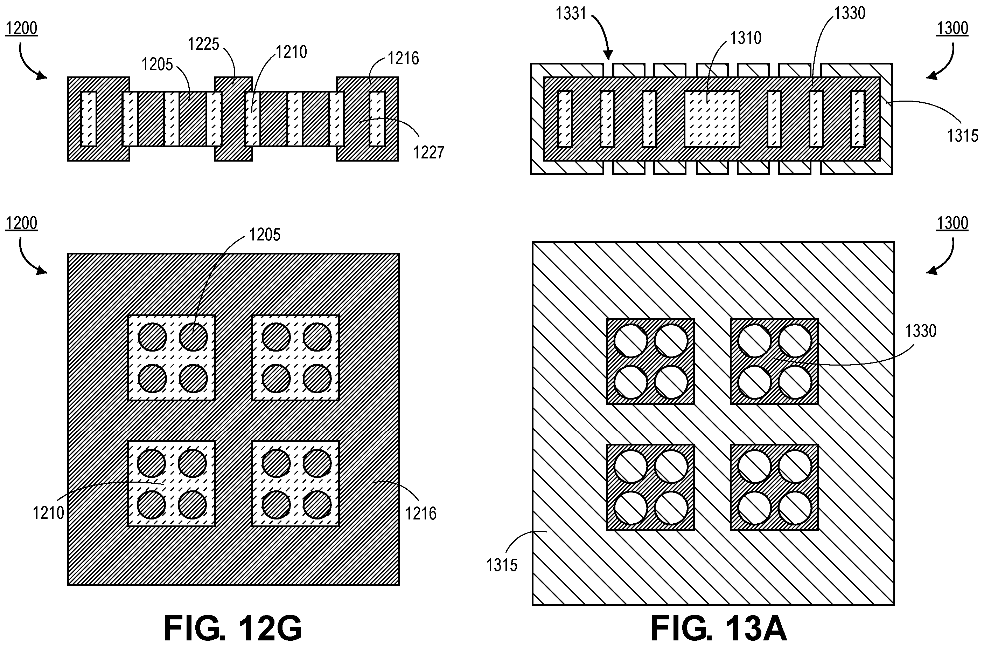

Referring now to Figure 12G, a plan view illustration and a corresponding cross-sectional illustration of the hybrid panel 1200 similar to Figure 12F, with the exception of the addition of a dummy via 1227 between the cross members 1225 on opposite sides of the glass substrate 1210. The dummy vias 1227 between the cross members 1225 may be formed as a hole in the original glass substrate 1210 before the initial plating operation to form the metal layer 1230.

Referring now to Figures 13A - 13D, a series of illustrations depicting a process for forming a hybrid panel 1300 is shown, in accordance with an embodiment. In Figures 13A - 13D, the bottom drawing is a plan view and the top drawing is a corresponding cross-sectional illustration.

Referring now to Figure 13A, a plan view illustration and a corresponding cross-sectional illustration of a hybrid panel 1300 at a stage of manufacture are shown, in accordance with an embodiment. In an embodiment, the hybrid panel 1300 may comprise a glass substrate 1310 with holes that are filled with a metal layer 1330. In an embodiment, the glass substrate 1310 and the metal layer 1330 may be formed with a process similar to the one described above with respect to Figures 12A -12B. In an embodiment, a resist layer 1315 may be patterned with openings 1331.

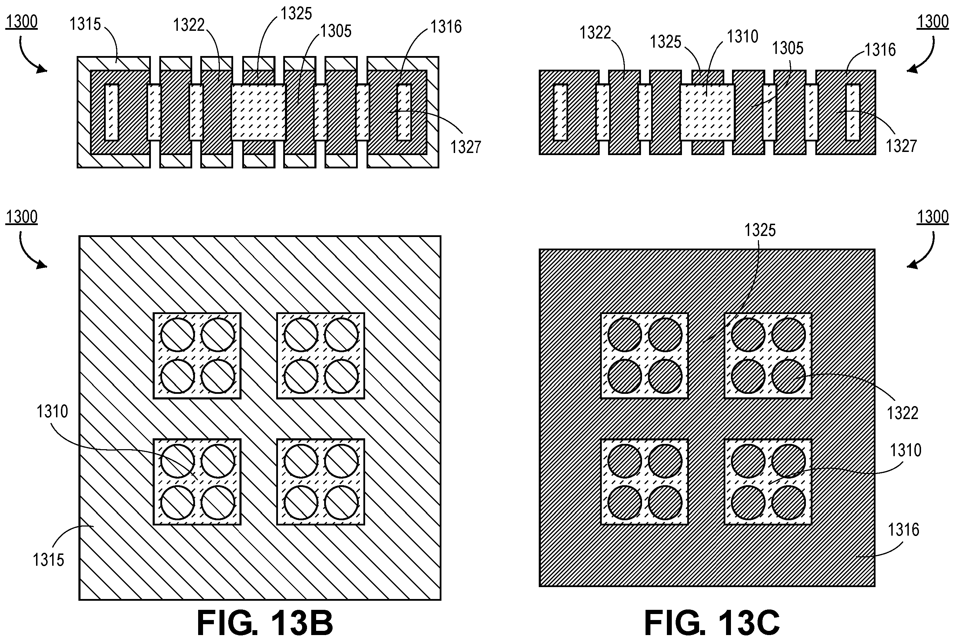

Referring now to Figure 13B, a plan view illustration and a corresponding cross-sectional illustration of a hybrid panel 1300 after the metal layer 1330 is etched to form a frame 1316 with dummy vias 1327. The etching may also define vias 1305 that include pads 1322 directly over the vias 1305.

Referring now to Figure 13C, a plan view illustration and a corresponding cross-sectional illustration of a hybrid panel 1300 after the resist layer 1315 is removed is shown, in accordance with an embodiment. The resist layer 1315 may be removed with any suitable resist stripping process.

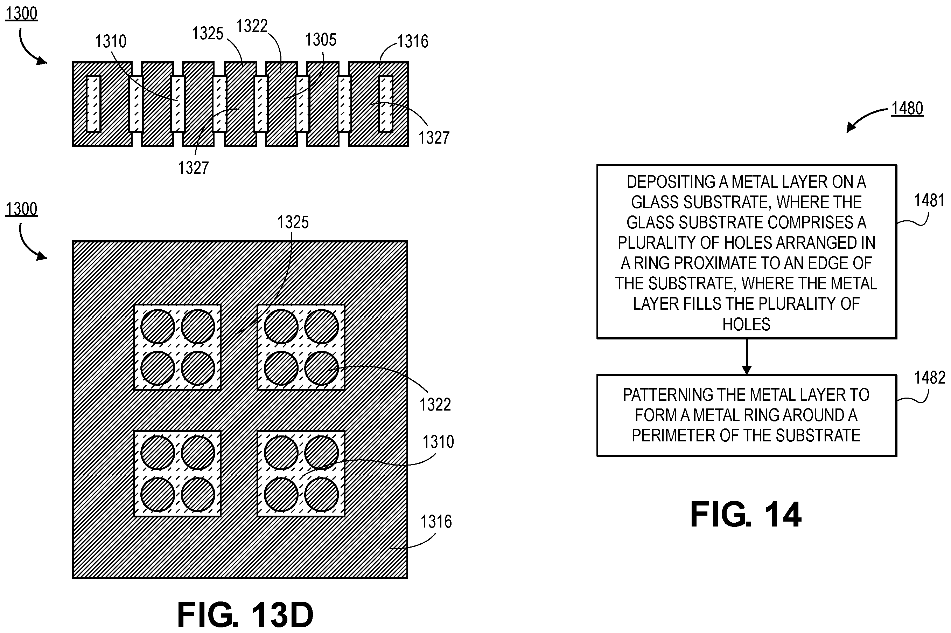

Referring now to Figure 13D, a plan view illustration and a corresponding cross-sectional illustration of the hybrid panel 1300 similar to Figure 13C, with the exception of the addition of a dummy via 1327 between the cross members 1325 on opposite sides of the glass substrate 1310. The dummy vias 1327 between the cross members 1325 may be formed as a hole in the original glass substrate 1310 before the initial plating operation to form the metal layer 1330.

Referring now to Figure 14, a flow diagram of a process 1480 for forming a hybrid panel with a frame that includes dummy vias is shown, in accordance with an embodiment. In an embodiment, the process 1480 may begin with operation 1481, which comprises depositing a metal layer on a glass substrate, where the glass substrate comprises a plurality of holes arranged in a ring proximate to an edge of the substrate. In an embodiment, the metal layer fills the plurality of holes. In an embodiment, the process 1480 may continue with operation 1482, which comprises patterning the metal layer to form a metal ring around a perimeter of the substrate. In an embodiment, the metal ring comprises dummy vias in the plurality of holes that mechanically couple the metal ring to the glass substrate.

In the embodiments described in greater detail above, the hybrid panels are formed with frames that are defined with the use of resist layers. However, in other embodiments the frames are defined with the use of carrier substrates that are attached over and under the glass substrate.

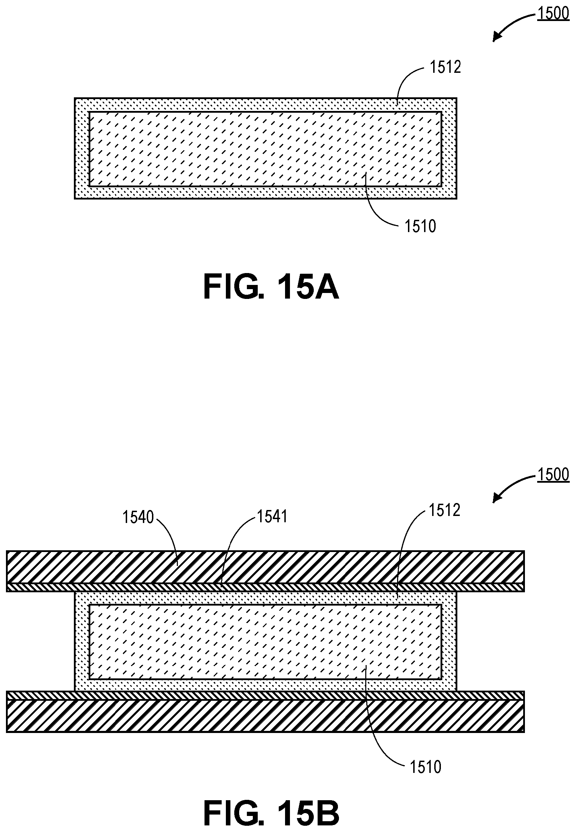

Referring now to Figures 15A - 15I, a series of cross-sectional illustrations depicting a process for forming hybrid panels 1500 with metal frames is shown, in accordance with an embodiment.

Referring now to Figure 15A, a cross-sectional illustration of a hybrid panel 1500 at a stage of manufacture is shown, in accordance with an embodiment. In an embodiment, the hybrid panel 1500 comprises a glass substrate 1510. The glass substrate 1510 may be similar to any of the glass substrates described in greater detail herein. In an embodiment, a seed layer 1512 is provided around the exposed surfaces of the glass substrate 1510. In an embodiment, the seed layer 1512 may be similar to any of the seed layers described in greater detail herein.

Referring now to Figure 15B, a cross-sectional illustration of the hybrid panel 1500 after carriers 1540 are attached to a top and bottom surface of the glass substrate 1510 is shown, in accordance with an embodiment. In an embodiment, the carriers 1540 may comprise a conductive material in order to aid in a subsequent plating process. For example, the carriers 1540 may comprise copper layers. In an embodiment, the carriers 1540 may be adhered to the glass substrate 1510 with an adhesive layer 1541. The adhesive layer 1541 may also comprise a conductive material, such as a conductive adhesive film or a conductive paste. In an embodiment, the carriers 1540 may be wider than the glass substrate 1510.

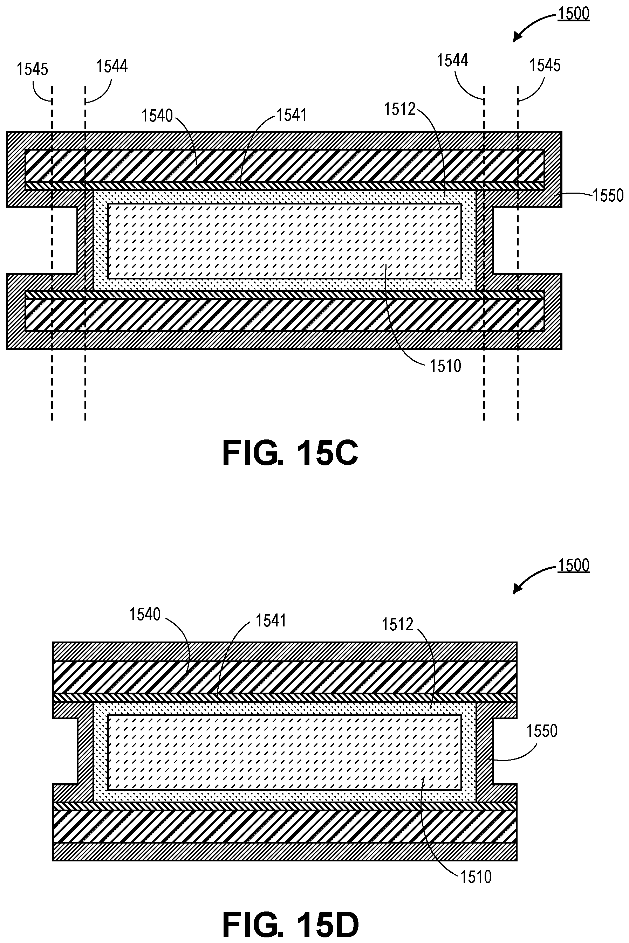

Referring now to Figure 15C, a cross-sectional illustration of the hybrid panel 1500 after a plating process to form a metal layer 1550 is shown, in accordance with an embodiment. In an embodiment, the plating process may include an electroplating process. In Figure 15C, cut lines 1544 and 1545 are shown. The cut lines 1544 run through the portion of the metal layer 1550 adjacent to the sidewalls of the glass substrate 1510, and the cut lines 1545 run through horizontal portions of the metal layer 1550 on the adhesive layer 1541.

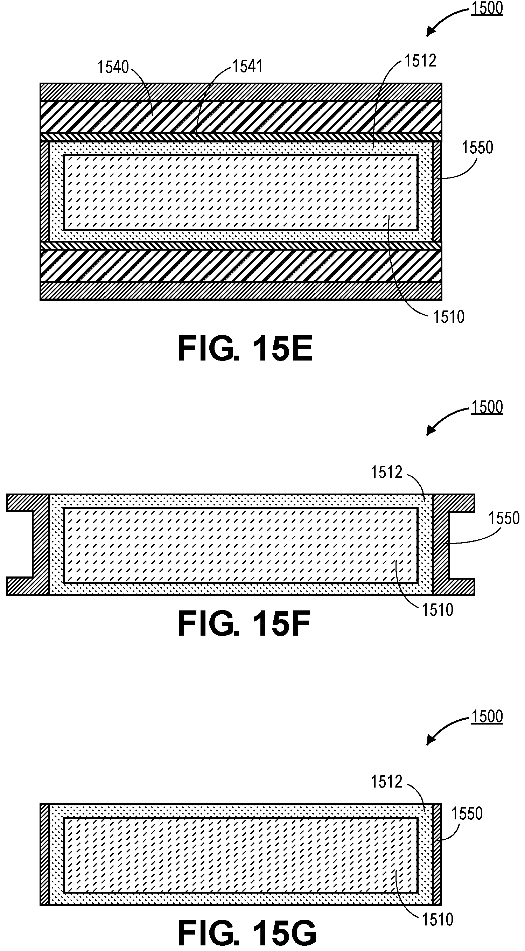

Referring now to Figure 15D, a cross-sectional illustration of the hybrid panel 1500 if the trimming is along the cut lines 1545 is shown, in accordance with an embodiment. In the illustrated embodiment, the metal layer 1550 along the sidewalls of the glass substrate 1510 have a C-shape (or a reverse C-shape). Figure 15E is a cross-sectional illustration of the hybrid panel 1500 if the trimming is along the cut line 1544. As shown, the metal layer along the sidewalls of the glass substrate 1510 will be substantially vertical.

Referring now to Figure 15F, a cross-sectional illustration of the hybrid panel 1500 after the carrier 1540 is removed from the device shown in Figure 15D is shown, in accordance with an embodiment. Figure 15G is a cross-sectional illustration of the hybrid panel 1500 after the carrier 1540 is removed from the device shown in Figure 15E. As shown in both Figure 15F and Figure 15G, the seed layers 1512 on the top and bottom surfaces of the glass substrate 1510 are exposed again.

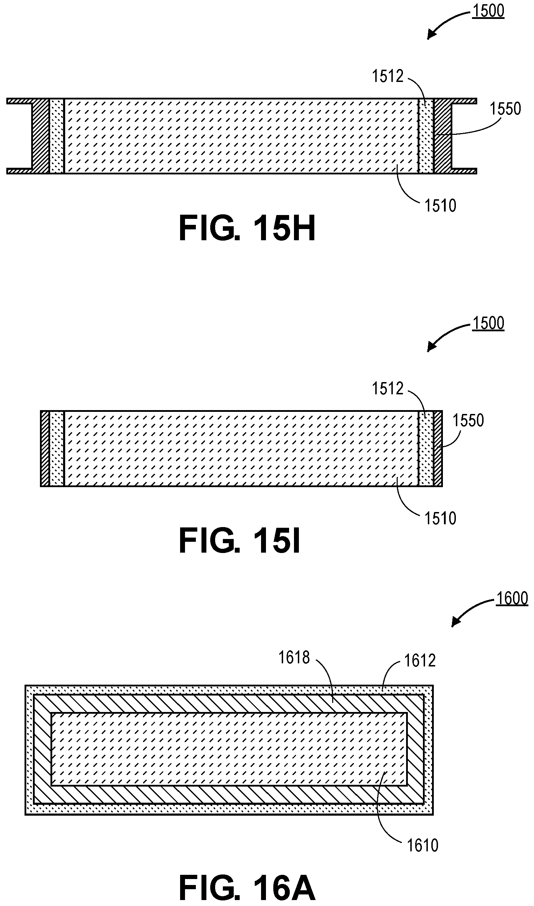

Referring now to Figure 15H, a cross-sectional illustration of the hybrid panel 1500 after the seed layer 1512 is removed from the device in Figure 15F is shown, in accordance with an embodiment. As shown, the resulting metal layer 1550 may have a vertical portion with protrusions at the top and bottom that extend away from the glass substrate 1510. Figure 15I is a cross-sectional illustration of the hybrid panel 1500 after the seed layer 1512 is removed from the device in Figure 15G. As shown, the resulting metal layer 1550 has only a vertical portion along the sidewalls of the glass substrate 1510. In both Figure 15H and 15I, the metal layer 1550 is only provided on the sidewalls of the glass substrate 1510. In some embodiments, the top surface of the metal layer 1550 is substantially coplanar with the top surface of the glass substrate 1510. That is, a thickness of the metal layer 1550 and a thickness of the glass substrate 1510 may be substantially similar.

Referring now to Figures 16A - 16I, a series of cross-sectional illustrations depicting a process for forming hybrid panels 1600 with glass substrates 1610 and buildup layers 1618 with metal frames is shown, in accordance with an embodiment.

Referring now to Figure 16A, a cross-sectional illustration of a hybrid panel 1600 at a stage of manufacture is shown, in accordance with an embodiment. In an embodiment, the hybrid panel 1600 comprises a glass substrate 1610. The glass substrate 1610 may be similar to any of the glass substrates described in greater detail herein. In an embodiment, a buildup layer 1618 may be provided around the glass substrate 1610. The buildup layer 1618 may be an organic buildup film or the like. In an embodiment, a seed layer 1612 is provided around the exposed surfaces of the buildup layer 1618. In an embodiment, the seed layer 1612 may be similar to any of the seed layers described in greater detail herein.

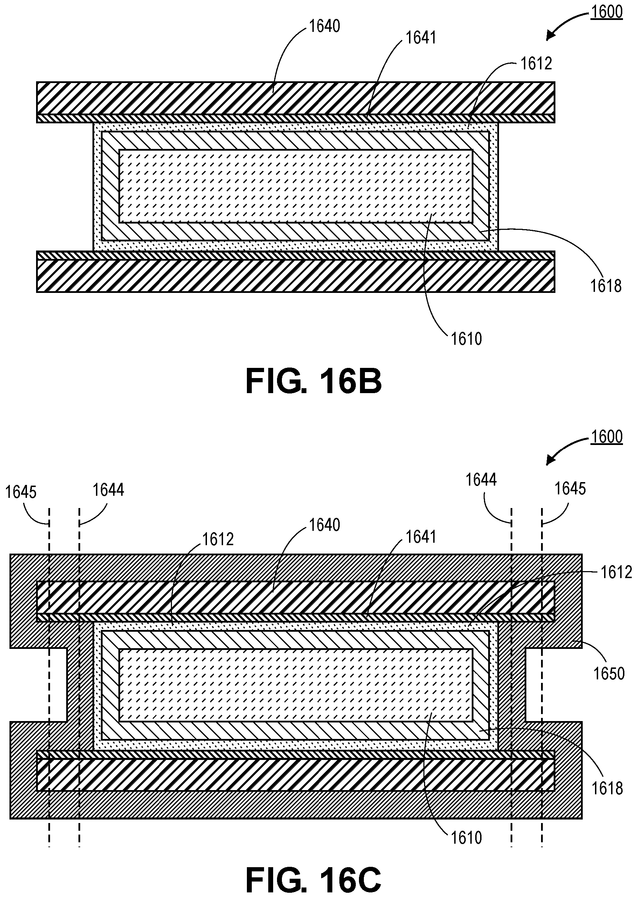

Referring now to Figure 16B, a cross-sectional illustration of the hybrid panel 1600 after carriers 1640 are attached to a top and bottom surface of the glass substrate 1610 is shown, in accordance with an embodiment. In an embodiment, the carriers 1640 may comprise a conductive material in order to aid in a subsequent plating process. For example, the carriers 1640 may comprise copper layers. In an embodiment, the carriers 1640 may be adhered to the glass substrate 1610 with an adhesive layer 1641. The adhesive layer 1641 may also comprise a conductive material, such as a conductive adhesive film or a conductive paste. In an embodiment, the carriers 1640 may be wider than the glass substrate 1610.

Referring now to Figure 16C, a cross-sectional illustration of the hybrid panel 1600 after a plating process to form a metal layer 1650 is shown, in accordance with an embodiment. In an embodiment, the plating process may include an electroplating process. In Figure 16C, cut lines 1644 and 1645 are shown. The cut lines 1644 run through the portion of the metal layer 1650 adjacent to the sidewalls of the glass substrate 1610, and the cut lines 1645 run through horizontal portions of the metal layer 1650 on the adhesive layer 1641.

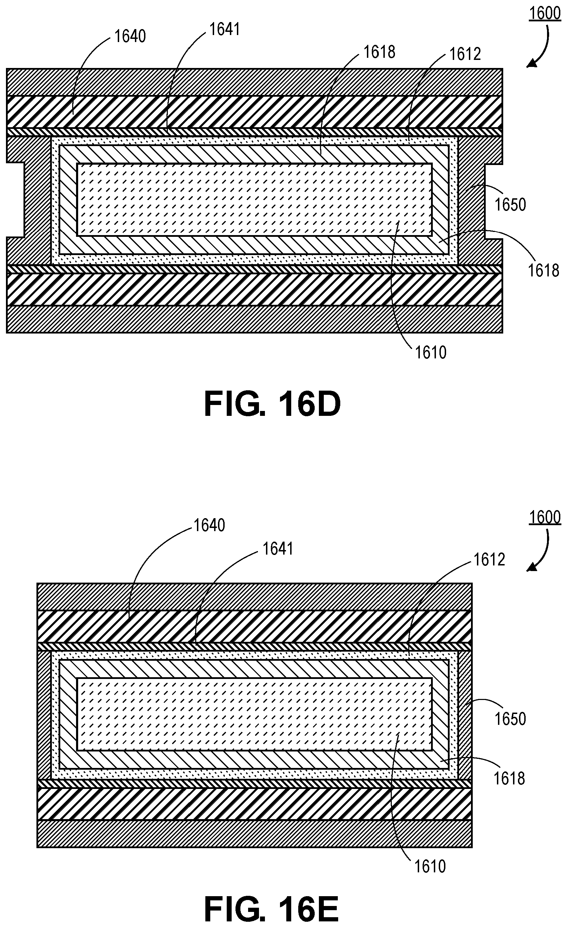

Referring now to Figure 16D, a cross-sectional illustration of the hybrid panel 1600 if the trimming is along the cut lines 1645 is shown, in accordance with an embodiment. In the illustrated embodiment, the metal layer 1650 along the sidewalls of the glass substrate 1610 have a C-shape (or a reverse C-shape). Figure 16E is a cross-sectional illustration of the hybrid panel 1600 if the trimming is along the cut line 1644. As shown, the metal layer along the sidewalls of the glass substrate 1610 will be substantially vertical.

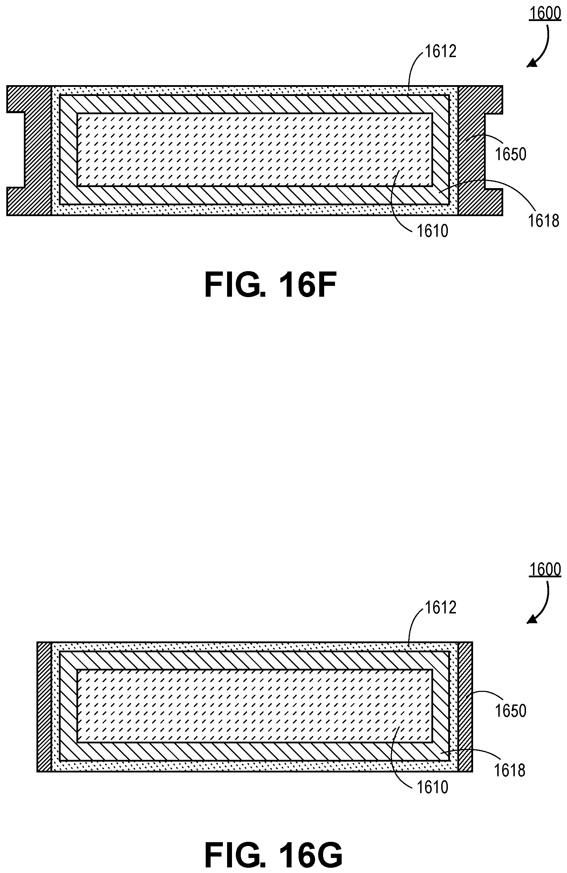

Referring now to Figure 16F, a cross-sectional illustration of the hybrid panel 1600 after the carrier 1640 is removed from the device shown in Figure 16D is shown, in accordance with an embodiment. Figure 16G is a cross-sectional illustration of the hybrid panel 1600 after the carrier 1640 is removed from the device shown in Figure 16E. As shown in both Figure 16F and Figure 16G, the seed layers 1612 on the top and bottom surfaces of the buildup layer 1618 are exposed again.

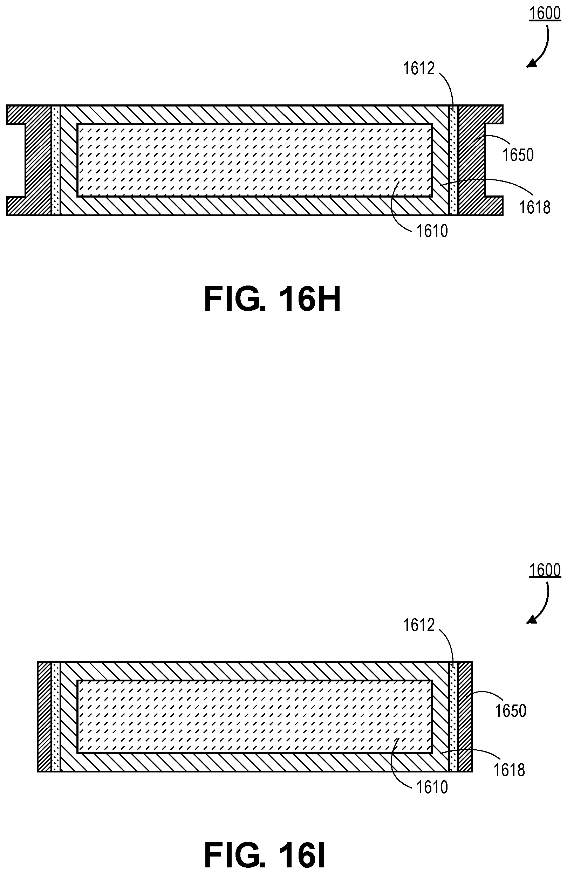

Referring now to Figure 16H, a cross-sectional illustration of the hybrid panel 1600 after the seed layer 1612 is removed from the device in Figure 16F is shown, in accordance with an embodiment. As shown, the resulting metal layer 1650 may have a vertical portion with protrusions at the top and bottom that extend away from the glass substrate 1610. Figure 16I is a cross-sectional illustration of the hybrid panel 1600 after the seed layer 1612 is removed from the device in Figure 16G. As shown, the resulting metal layer 1650 has only a vertical portion along the sidewalls of the glass substrate 1610. In both Figure 16H and 16I, the metal layer 1650 is only provided on the sidewalls of the glass substrate 1610. In some embodiments, the top surface of the metal layer 1650 is substantially coplanar with the top surface of the buildup layer 1618. That is, a thickness of the metal layer 1650 may be substantially equal to a combined thickness of the glass substrate 1610 and the buildup layer 1618.

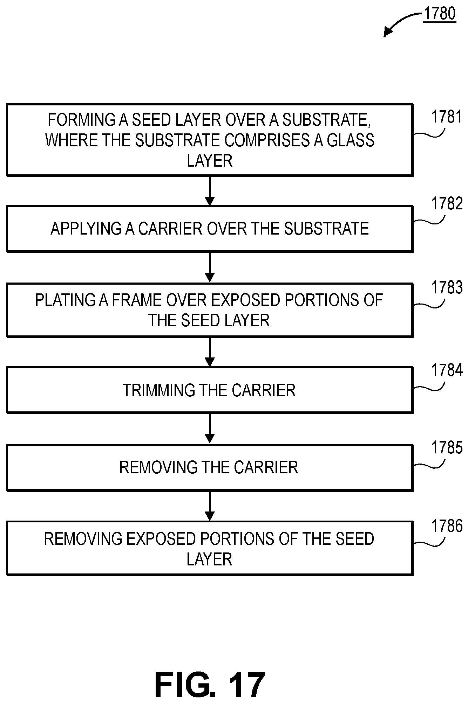

Referring now to Figure 17, a flow diagram of a process 1780 for forming a hybrid panel with a frame around a glass substrate with the use of carriers is shown, in accordance with an embodiment. In an embodiment, the process 1780 may begin with operation 1781, which comprises forming a seed layer over a substrate, where the substrate comprises a glass layer. A buildup layer may also be provided between the seed layer and the substrate. In an embodiment, the process 1780 may continue with operation 1782, which comprises applying a carrier over the substrate. In an embodiment, the carrier may be attached to the substrate with an adhesive layer. The carrier and the adhesive layer may both be electrically conductive materials in some embodiments.

In an embodiment, the process 1780 may continue with operation 1783, which comprises plating a frame over exposed portions of the seed layer. The process 1780 may then continue with operation 1784, which comprises trimming the carrier. In an embodiment, the trimming may occur along a line that allows for a vertical frame, or the trimming may occur along a line that allows for a C-shaped frame.

In an embodiment, the process 1780 may continue with operation 1785, which comprises removing the carrier. The carrier may be removed with any suitable process. In an embodiment, the process 1780 may continue with operation 1786, which comprises removing exposed portions of the seed layer. The seed layer may be removed with an etching process.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a substrate, wherein the substrate comprises a glass layer; and a frame around a perimeter of the substrate, wherein the frame is over a top surface, a bottom surface, and a sidewall surface of the substrate, and wherein the frame comprises a conductive material.

Example 2: the apparatus of Example 1, wherein the frame is separated from the substrate by a seed layer.

Example 3: the apparatus of Example 1 or Example 2, wherein the frame is separated from the substrate by an organic dielectric layer.

Example 4: the apparatus of Example 3, wherein the organic dielectric layer is separated from the substrate by an inorganic layer.

Example 5: the apparatus of Example 4, wherein the inorganic layer comprises silicon and nitrogen.

Example 6: the apparatus of Examples 1-5, further comprising: a layer over a top surface of the frame and the top surface of the substrate, wherein the layer comprises an organic dielectric material.

Example 7: the apparatus of Example 6, wherein the layer is conformal to the frame and the top surface of the substrate.

Example 8: the apparatus of Examples 1-7, wherein the frame comprises copper.

Example 9: the apparatus of Examples 1-8, wherein the frame further comprising a cross over the top surface of the substrate.

Example 10: the apparatus of Examples 1-9, wherein the substrate has a panel form factor or a quarter panel form factor.

Example 11: an apparatus, comprising: a substrate, wherein the substrate comprises a glass layer; a hole through a thickness of the substrate; and a frame around a perimeter of the substrate, wherein the frame comprises a via that at least partially fills the hole.

Example 12: the apparatus of Example 11, wherein the frame is over a top surface of the substrate, a bottom surface of the substrate, and a sidewall surface of the substrate.

Example 13: the apparatus of Example 11 or Example 12, further comprising: a plurality of holes through the substrate arranged in a ring pattern proximate to a perimeter of the substrate, and wherein the frame comprises a plurality of vias through the plurality of holes.

Example 14: the apparatus of Examples 11-13, wherein the frame comprises a metallic material.

Example 15: the apparatus of Examples 11-14, wherein the frame comprises a cross over the substrate.

Example 16: the apparatus of Example 15, wherein the frame comprises a via directly coupled to the cross.

Example 17: an apparatus, comprising: a substrate, wherein the substrate comprises a glass layer; and a frame coupled to a sidewall of the substrate, wherein the frame comprises: a first protrusion that extends away from the substrate at a top of the frame; and a second protrusion that extends away from the substrate at a bottom of the frame.

Example 18: the apparatus of Example 17, wherein the frame comprises a metallic material.

Example 19: the apparatus of Example 17 or Example 18, wherein the frame is separated from the substrate by an organic dielectric layer.

Example 20: the apparatus of Examples 17-19, wherein a thickness of the frame is substantially equal to a thickness of the substrate.

## Claims

1. An apparatus, comprising:
a substrate, wherein the substrate comprises a glass layer; and
a frame around a perimeter of the substrate, wherein the frame is over a top surface, a bottom surface, and a sidewall surface of the substrate, and wherein the frame comprises a conductive material.

2. The apparatus of claim 1, wherein the frame is separated from the substrate by a seed layer.

3. The apparatus of claim 1 or 2, wherein the frame is separated from the substrate by an organic dielectric layer.

4. The apparatus of claim 3, wherein the organic dielectric layer is separated from the substrate by an inorganic layer.

5. The apparatus of claim 4, wherein the inorganic layer comprises silicon and nitrogen.

6. The apparatus of claim 1, 2, 3, 4 or 5, further comprising:
a layer over a top surface of the frame and the top surface of the substrate, wherein the layer comprises an organic dielectric material.

7. The apparatus of claim 6, wherein the layer is conformal to the frame and the top surface of the substrate.

8. The apparatus of claim 1, 2, 3, 4, 5, 6 or 7, wherein the frame comprises copper.

9. The apparatus of claim 1, 2, 3, 4, 5, 6, 7 or 8, wherein the frame further comprising a cross over the top surface of the substrate.

10. The apparatus of claim 1, 2, 3, 4, 5, 6, 7, 8 or 9, wherein the substrate has a panel form factor or a quarter panel form factor.

11. A method of fabricating an apparatus, the method comprising:
providing a substrate, wherein the substrate comprises a glass layer; and
forming a frame around a perimeter of the substrate, wherein the frame is over a top surface, a bottom surface, and a sidewall surface of the substrate, and wherein the frame comprises a conductive material.

12. The method of claim 11, wherein the frame is separated from the substrate by a seed layer.

13. The method of claim 11 or 12, wherein the frame is separated from the substrate by an organic dielectric layer.

14. The method of claim 13, wherein the organic dielectric layer is separated from the substrate by an inorganic layer.

15. The method of claim 14, wherein the inorganic layer comprises silicon and nitrogen.
